# EUROPEAN PATENT APPLICATION

(11) **EP 4 783 766 A1**
(43) Date of publication of application: **29.07.2026**
(21) Application number: 25212118.1
(22) Date of filing: 29.10.2025
(51) Int. Cl.: H10B 12/00, G11C 7/18

(54) **INTEGRATED CIRCUIT DEVICE**

(30) Priority: 23.01.2025 KR 20250010674
(71) Applicant: Samsung Electronics Co., Ltd., Suwon-si, Gyeonggi-do 16677 (KR)
(72) Inventor: KIM, Kyounghwan, 16677 Suwon-si (KR); KIM, Kangin, 16677 Suwon-si (KR); KIM, Hyungjoon, 16677 Suwon-si (KR); AHN, Sangbin, 16677 Suwon-si (KR); JUNG, Yongmin, 16677 Suwon-si (KR); CHO, Youngseung, 16677 Suwon-si (KR)
(74) Representative: Marks & Clerk LLP

(57) **Abstract**

An integrated circuit device includes a substrate including a cell array region, a core region, and an interface region between the cell array region and the core region, an interface device isolation film arranged in the interface region and defining the cell array region, a plurality of dummy active regions spaced apart from each other in the interface region, each dummy active region being surrounded by the interface device isolation film, and a plurality of bit lines extending from the cell array region to the interface region, wherein each of the plurality of bit lines includes a bit line extension located in the interface region, and the bit line extension extends onto a selected one of the plurality of dummy active regions.

## Description

### BACKGROUND

The inventive concept relates to an integrated circuit (IC) device, and more particularly, to an IC device including a plurality of bit lines.

Due to the development of electronics technology, the downscaling of IC devices has rapidly progressed in recent years, and a feature size of IC devices is being reduced. Accordingly, it is necessary to develop a structure capable of ensuring the reliability of unit devices arranged in a cell array region.

### SUMMARY

The inventive concept provides an integrated circuit (IC) device having a structure, which may prevent a short-circuit from occurring between adjacent ones of bit lines arranged in a cell array region and an interface region adjacent thereto, and may improve reliability by increasing a contact area between each of the bit lines and a contact plug corresponding thereto.

According to an aspect of the inventive concept, there is provided an IC device including a substrate including a cell array region, a core region, and an interface region between the cell array region and the core region, an interface device isolation film arranged in the interface region and defining the cell array region, a plurality of dummy active regions spaced apart from each other in the interface region, each dummy active region being surrounded by the interface device isolation film, and a plurality of bit lines extending from the cell array region to the interface region, wherein each of the plurality of bit lines includes a bit line extension located in the interface region, and the bit line extension extends onto a selected one of the plurality of dummy active regions.

According to another aspect of the inventive concept, there is provided an IC device including a substrate including a cell array region, a core region surrounding the cell array region, and an interface region between the cell array region and the core region, an interface device isolation film in the interface region, the interface device isolation film defining the cell array region, and a plurality of bit lines on the substrate in the cell array region and the interface region, the plurality of bit lines being spaced apart from each other in a first lateral direction and extending in a second lateral direction perpendicular to the first lateral direction, and each bit line including a bit line extension located in the interface region; and a plurality of dummy active regions in first and second local regions, the plurality of dummy active regions defined by the interface device isolation film in the substrate, wherein the first and second local regions are selected in the interface region and spaced apart from each other in the second lateral direction with the cell array region therebetween, wherein the plurality of dummy active regions are spaced apart from each other in the first lateral direction in each of the first and second local regions and are arranged in a line in the first lateral direction, and a portion of an end of the bit line extension, which is far from the cell array region, in each of the plurality of bit lines is arranged at a position overlapping a selected one of the plurality of dummy active regions in a vertical direction in the interface region.

According to another aspect of the inventive concept, there is provided an IC device including a substrate including a cell array region, a core region, and an interface region between the cell array region and the core region, an interface device isolation film arranged in the interface region and defining the cell array region, a plurality of bit lines on the substrate in the cell array region and the interface region, each bit line including a bit line extension located in the interface region, a plurality of dummy active regions in first and second local regions, the plurality of dummy active regions being defined by the interface device isolation film in the substrate, wherein the first and second local regions are selected in the interface region and spaced apart from each other with the cell array region therebetween, and a plurality of contact plugs respectively extending from above the plurality of bit lines to the plurality of bit lines in a vertical direction, the plurality of contact plugs being respectively connected to the bit line extensions of the plurality of bit lines on the plurality of dummy active regions, wherein the plurality of dummy active regions are spaced apart from each other in a first lateral direction in each of the first and second local regions, the plurality of dummy active regions are arranged in a line in the first lateral direction, and each of the plurality of dummy active regions is arranged at a position overlapping the bit line extension of a selected one of the plurality of bit lines in a vertical direction, and
each of the plurality of contact plugs is in contact with at least four surfaces facing in different directions, from among surfaces included in the bit line extension of a selected one of the plurality of bit lines.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram of an example of a configuration of an integrated circuit (IC) device according to embodiments;
FIG. 2 is a diagram of an example of a layout configuration of the IC device illustrated in FIG. 1;
FIG. 3 illustrates a schematic plan layout illustrating main components of a memory cell array included in a cell array region illustrated in FIG. 2;
FIG. 4 is an enlarged plan view of some components included in a partial region of a portion denoted by "EX2" in FIG. 2;
FIG. 5 is a cross-sectional view taken along line X1 - X1' of FIG. 3;
FIG. 6 is a cross-sectional view taken along line X2 - X2' of FIG. 3;
FIG. 7 is a cross-sectional view taken along line X3 - X3' of FIG. 4;
FIG. 8 is a cross-sectional view taken along line X4 - X4' of FIG. 4;
FIG. 9 is a cross-sectional view taken along line Y1 - Y1' of FIG. 4 and an extension thereof;
FIG. 10 is a cross-sectional view taken along line Y2 - Y2' of FIG. 4 and an extension thereof;
FIG. 11 illustrates an example of a plan layout of one cell array region, an interface device isolation film located adjacent thereto, and a plurality of dummy active regions in an IC device according to embodiments;
FIG. 12A and FIG. 12B are cross-sectional views of an IC device, according to embodiments; and

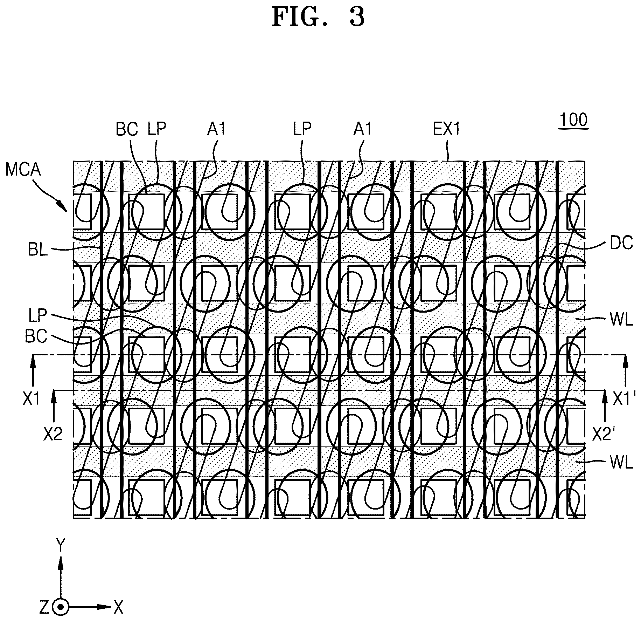

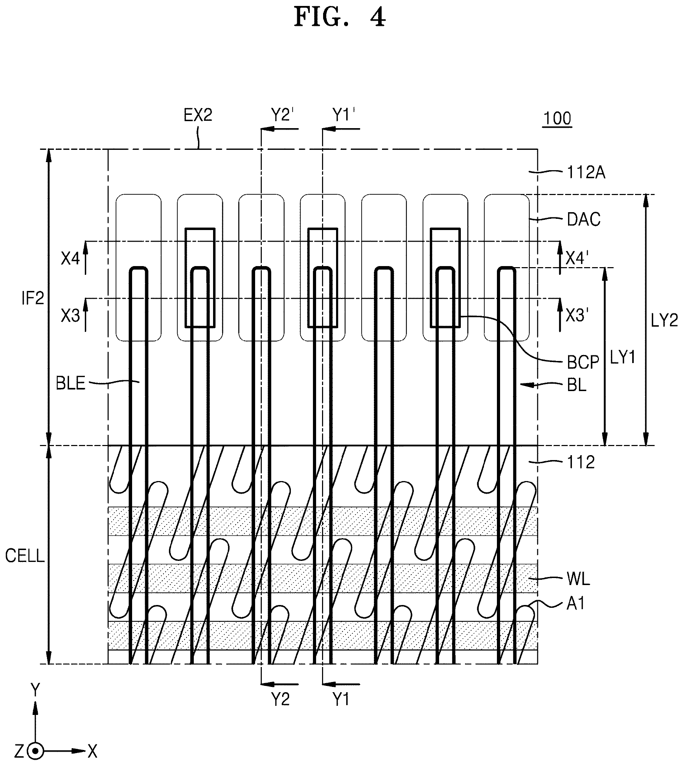

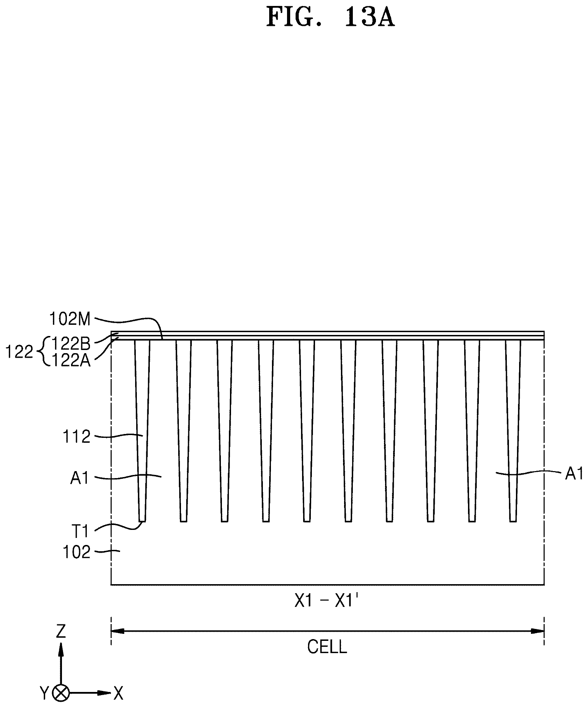

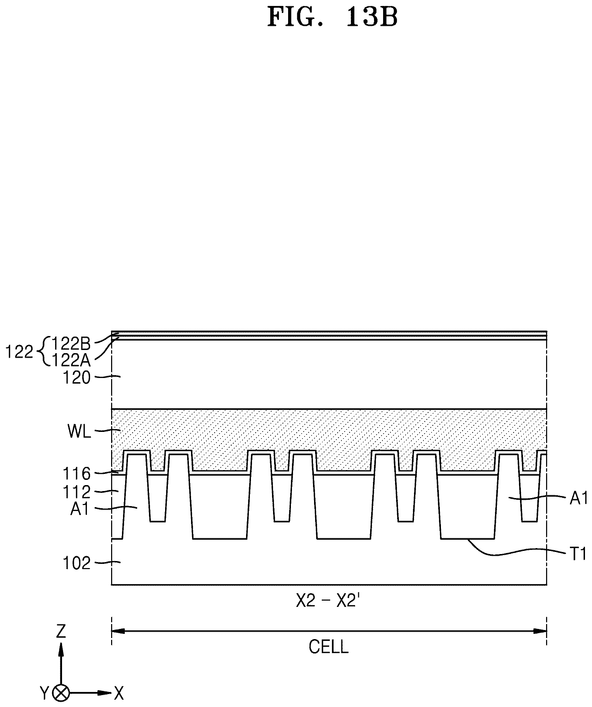

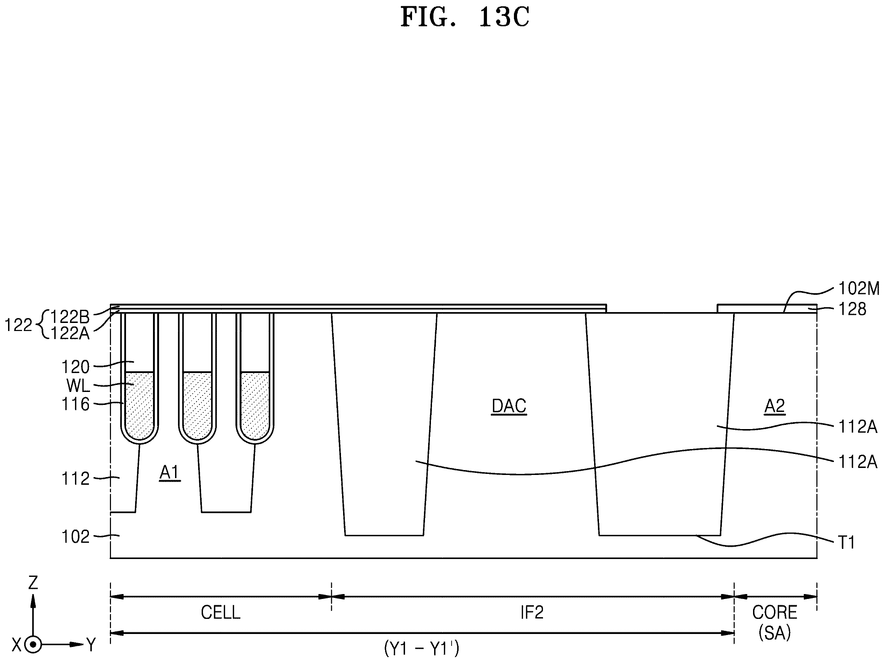

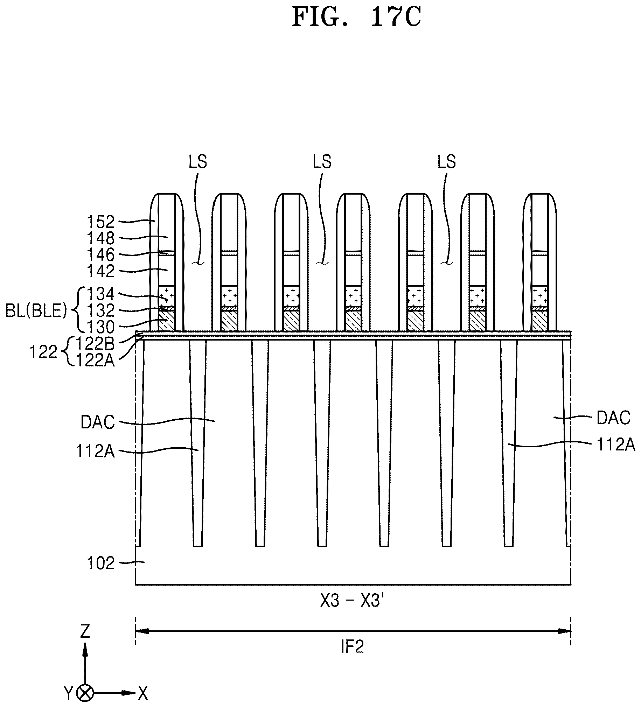

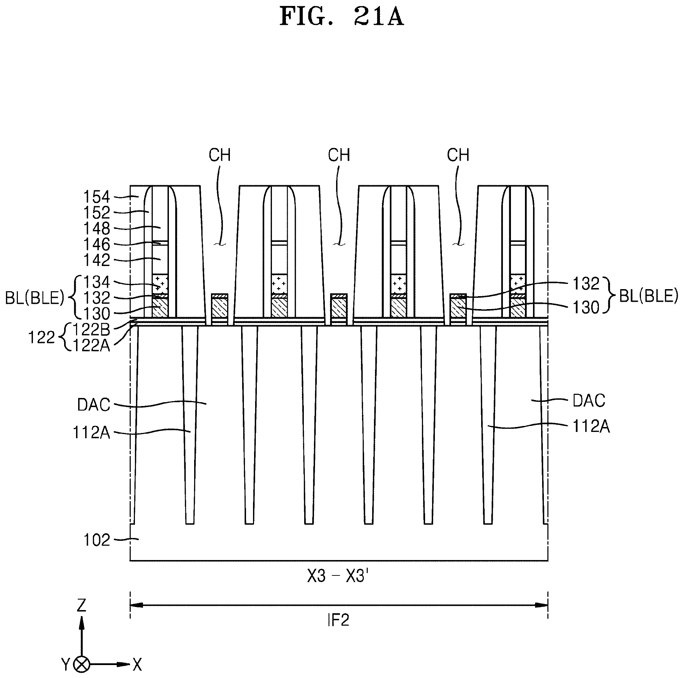

FIG. 13A, FIG. 13B, FIG. 13C, FIG. 14A, FIG. 14B, FIG. 15A, FIG. 15B, FIG. 15C, FIG. 16A, FIG. 16B, FIG. 16C, FIG. 17A, FIG. 17B, FIG. 17C, FIG. 17D, FIG. 18A, FIG. 18B, FIG. 18C, FIG. 18D, FIG. 19, FIG. 20. FIG. 21A, FIG. 21B, FIG. 22A, FIG. 22B, FIG. 22C, FIG. 23A, FIG. 23B, and FIG. 23C are diagrams illustrating a process sequence of a method of manufacturing an IC device, according to embodiments, wherein FIGS. 13A, 14A, 15A, 16A, 17A, 18A, 19, 20, 22A, and 23A are cross-sectional views of a portion corresponding to a cross-section taken along line X1-X1' of FIG. 3, according to the process sequence, FIGS. 13B, 14B, 15B, 16B, 17B, and 18B are cross-sectional views of a portion corresponding to a cross-section taken along line X2-X2' of FIG. 3, according to the process sequence, FIGS. 17C, 18C, 21A, 22B, and 23B are cross-sectional views of a portion corresponding to a cross-section taken along line X3-X3' of FIG. 4, according to the process sequence, and FIGS. 13C, 15C, 16C, 17D, 18D, 21B, 22C, and 23C are cross-sectional views of a portion corresponding to a cross-section taken along line Y1-Y1' of FIG. 4, according to the process sequence.

### DETAILED DESCRIPTION OF THE EMBODIMENTS

Hereinafter, embodiments will be described in detail with reference to the accompanying drawings. The same reference numerals are used to denote the same elements in the drawings, and repeated descriptions thereof will be omitted.

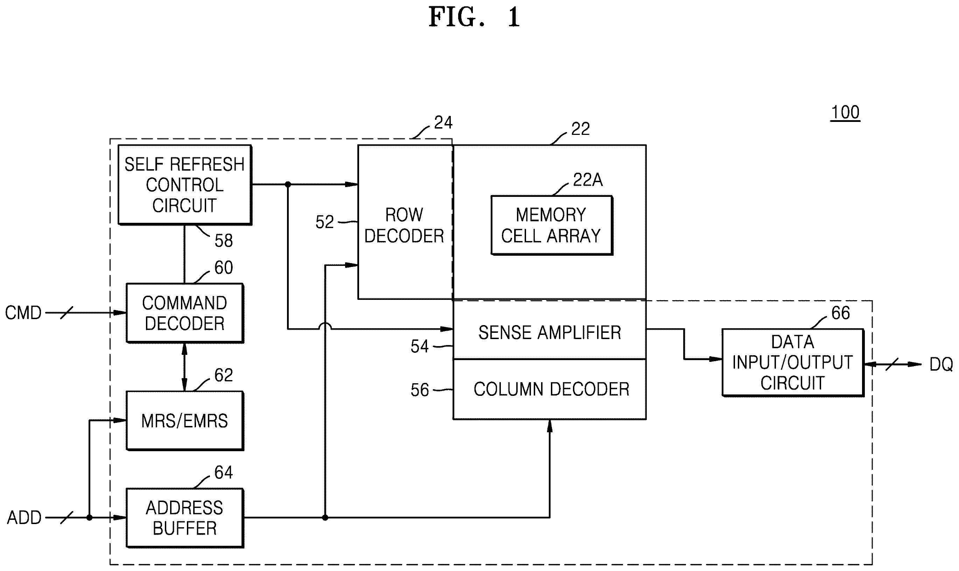

FIG. 1 is a block diagram of an example of a configuration of an integrated circuit (IC) device 100 according to embodiments.

Referring to FIG. 1, the IC device 100 may include a first region 22 and a second region 24. The first region 22 may be a memory cell region of a dynamic random access memory (DRAM) device, and the second region 24 may include a region in which peripheral circuits of the DRAM device are formed and a core region (hereinafter, a "peripheral circuit region"). The first region 22 may include a memory cell array 22A. The second region 24 may include a row decoder 52, a sense amplifier 54, a column decoder 56, a self-refresh control circuit 58, a command decoder 60, a mode register set/extended mode register set (MRS/EMRS) 62, an address buffer 64, and a data input/output (I/O) circuit 66. Peripheral circuits, such as an inverter chain and an I/O circuit, may be further formed in the second region 24 of FIG. 1.

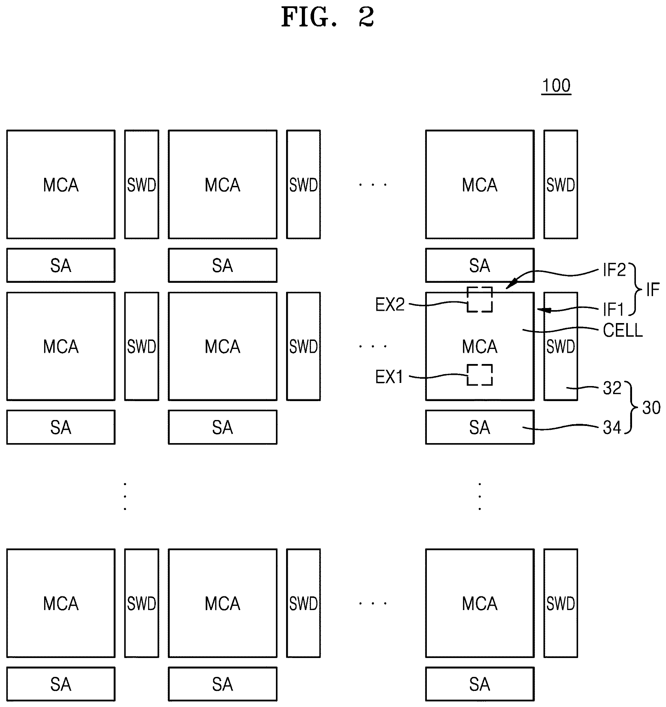

FIG. 2 is a diagram of an example of a layout configuration of the IC device 100 illustrated in FIG. 1.

Referring to FIGS. 1 and 2, the first region 22 of the IC device 100 may include a plurality of cell array regions CELL and a core region 30 surrounding the plurality of cell array regions CELL. The plurality of cell array regions CELL may correspond to a portion of the first region 22 illustrated in FIG. 1. The core region 30 may be a portion of the second region 24 illustrated in FIG. 1. The core region 30 may include a sub-word line driver region 32 adjacent to one side of the cell array region CELL and a sense amplifier region 34 adjacent to another side of the cell array region CELL. In FIG. 2, "MCA" denotes a memory cell array located in the cell array region CELL and may correspond to the memory cell array 22A illustrated in FIG. 1. In FIG. 2, "SWD" denotes a sub-word line driver block located in the core region 30, and the sub-word line driver region 32 may also be referred to as a sub-word line driver region SWD. "SA" denotes a sense amplifier block located in the core region 30, and the sense amplifier region 34 may also be referred to as a sense amplifier region SA.

An interface region IF may be between the cell array region CELL and the core region 30. The interface region IF may include a first interface region IF1 between the cell array region CELL and the sub-word line driver region SWD and a second interface region IF2 between the cell array region CELL and the sense amplifier region SA.

The sub-word line driver region SWD may include circuits configured to drive a plurality of word lines arranged in the cell array region CELL. The sense amplifier region SA may include a sense amplifier configured to sense and amplify signals of a plurality of bit lines arranged in the cell array region CELL.

In the core region 30, a conjunction block may be located at an intersection between the sub-word line driver region SWD and the sense amplifier region SA. Power drivers and ground drivers configured to drive bit line sense amplifiers may be arranged in the conjunction block.

FIG. 3 illustrates a schematic plan layout illustrating main components of the memory cell array MCA included in the cell array region CELL illustrated in FIG. 2. The plan layout illustrated in FIG. 3 may correspond to a partial region of a portion denoted by "EX1" in FIG. 2.

Referring to FIG. 3, the memory cell array MCA may include a plurality of cell active regions A1. Each of the plurality of cell active regions A1 may be arranged to have a major axis in an oblique direction to a first lateral direction (X direction) and a second lateral direction (Y direction), which are perpendicular to each other. The first lateral direction and the second lateral direction may be otherwise known as a first direction and a second direction, respectively. The plurality of word lines WL may intersect with the plurality of cell active regions A1 and extend parallel to each other in the first lateral direction (X direction). On the plurality of word lines WL, a plurality of bit lines BL may extend parallel to each other in the second lateral direction (Y direction). The first lateral direction (X direction) and the second lateral direction (Y direction) may be perpendicular to each other.

The plurality of bit lines BL may be connected to the plurality of cell active regions A1 through direct contacts DC. A plurality of buried contacts BC may be located between two adjacent ones of the plurality of bit lines BL. In the memory cell array MCA, the plurality of buried contacts BC may be arranged in a line in the first lateral direction (X direction) and the second lateral direction (Y direction). A plurality of conductive landing pads LP may be arranged on the plurality of buried contacts BC. The plurality of buried contacts BC and the plurality of conductive landing pads LP may connect lower electrodes (not shown) of capacitors formed on the plurality of bit lines BL to the cell active regions A1. Each of the plurality of conductive landing pads LP may partially overlap the buried contact BC. The plurality of conductive landing pads LP may be configured to be connected to the cell active regions A1 through the buried contacts BC.

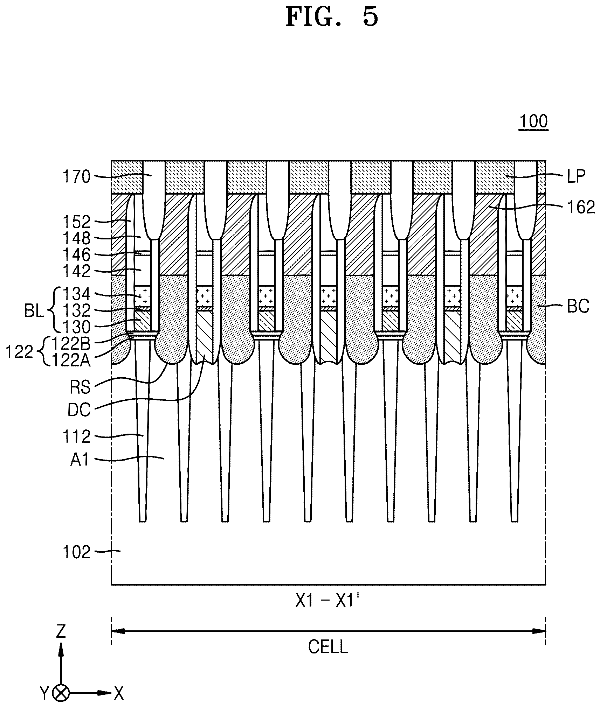

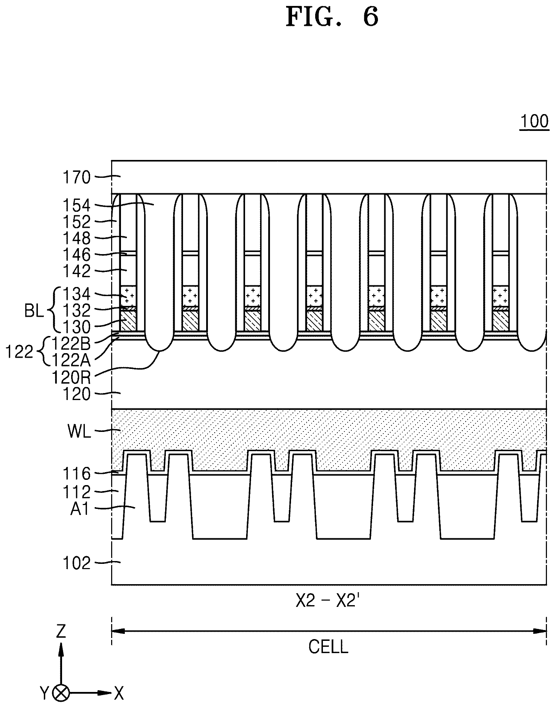

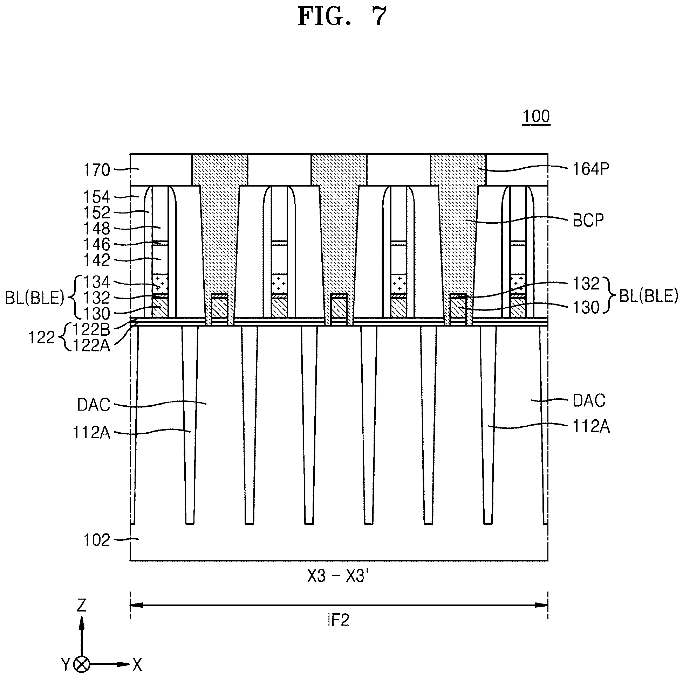

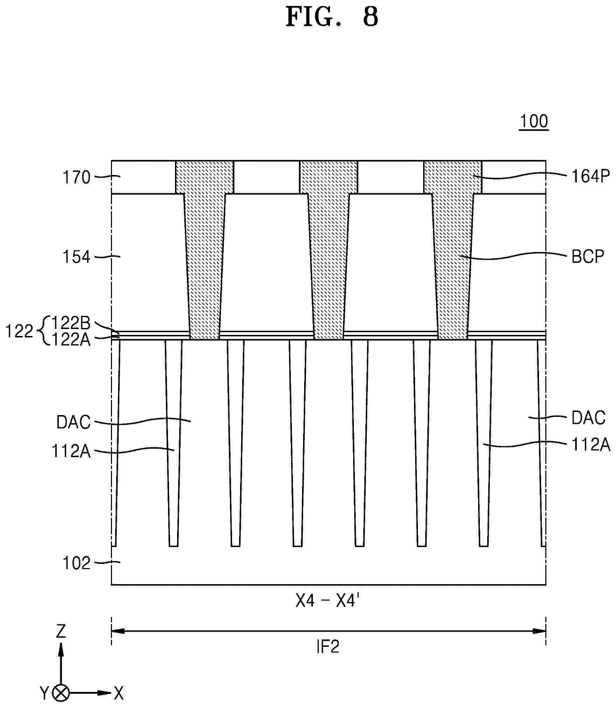

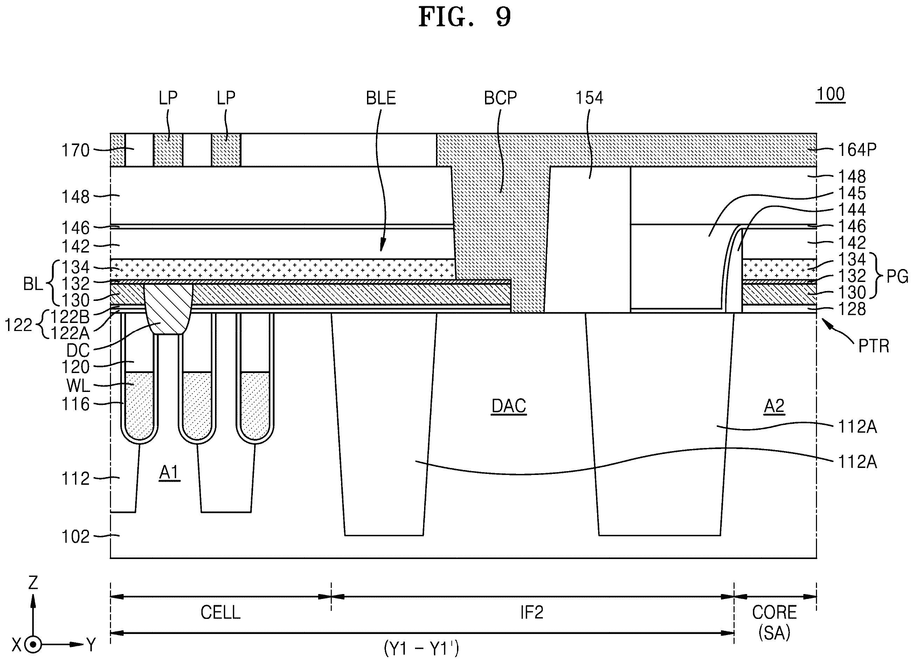

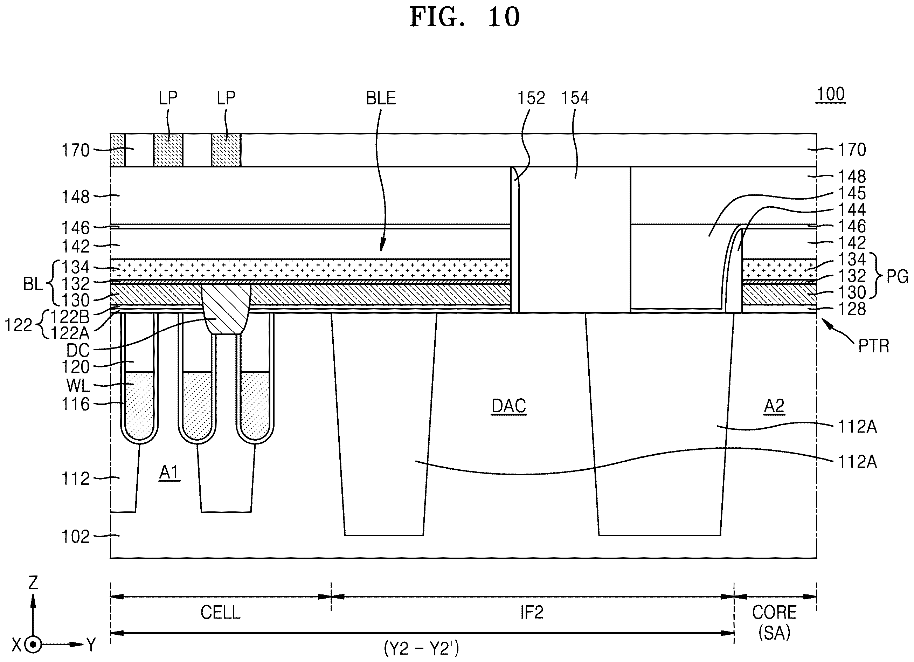

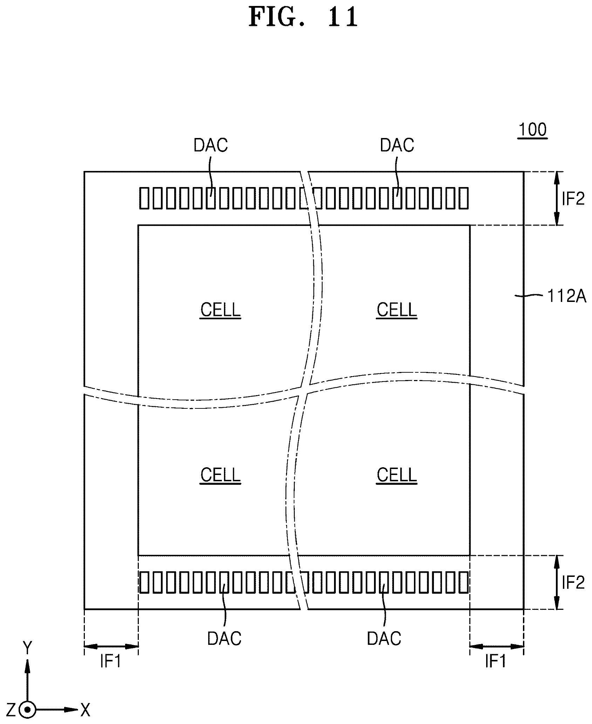

FIG. 4 is an enlarged plan view of some components included in a partial region of a portion denoted by "EX2" in FIG. 2. FIGS. 5 and 6 are each a cross-sectional view of a partial region of a cell array region CELL. A configuration corresponding to a cross-section taken along line X1-X1' of FIG. 3 is illustrated in FIG. 5, and a configuration corresponding to a cross-section taken along line X2-X2' of FIG. 3 is illustrated in FIG. 6. FIG. 7 is a cross-sectional view taken along line X3 - X3' of FIG. 4, FIG. 8 is a cross-sectional view taken along line X4 - X4' of FIG. 4, FIG. 9 is a cross-sectional view taken along line Y1 - Y1' of FIG. 4 and an extension thereof, and FIG. 10 is a cross-sectional view taken along line Y2 - Y2' of FIG. 4 and an extension thereof. FIG. 11 illustrates an example of a plan layout of one cell array region CELL, an interface device isolation film 112A located adjacent thereto, and a plurality of dummy active regions DAC defined by the interface device isolation film 112A in an IC device 100.

The IC device 100 is described in further detail with reference to FIGS. 3 to 11. The IC device 100 may include a substrate 102. The substrate 102 may include the cell array region CELL, a peripheral circuit region including a core region CORE surrounding the cell array region CELL, and an interface region IF between the cell array region CELL and the core region CORE. The core region CORE may correspond to the core region 30 illustrated in FIG. 4. The core region CORE may include a sub-word line driver region SWD adjacent to the cell array region CELL in a first lateral direction (X direction) and a sense amplifier region SA adjacent to the cell array region CELL in a second lateral direction (Y direction). The interface region IF may include a first interface region IF1 between the cell array region CELL and the sub-word line driver region SWD and a second interface region IF2 between the cell array region CELL and the sense amplifier region SA.

The substrate 102 may include silicon, for example, single crystalline silicon, polycrystalline silicon, or amorphous silicon. In some embodiments, the substrate 102 may include at least one selected from germanium (Ge), silicon germanium (SiGe), silicon carbide (SiC), gallium arsenide (GaAs), indium arsenide (InAs), and indium phosphide (InP). In some embodiments, the substrate 102 may include a conductive region, for example, a doped well or a doped structure.

A device isolation film 112 may be located in the substrate 102. In the cell array region CELL, a plurality of cell active regions A1 may be defined by the device isolation film 112 in the substrate 102. The interface device isolation film 112A defining the cell array region CELL may be located in the interface region IF. A peripheral active region A2 may be defined by the interface device isolation film 112A in the substrate 102 in an area of the core region CORE, which is adjacent to the interface region IF. The interface device isolation film 112A may have a greater width than the device isolation film 112 located in the cell array region CELL in the first lateral direction (X direction) and the second lateral direction (Y direction). The interface device isolation film 112A may be located between the cell array region CELL and the core region CORE to separate the cell array region CELL from the core region CORE. The device isolation film 112 and the interface device isolation film 112A may have various depths depending on position. In embodiments, each of the device isolation film 112 and the interface device isolation film 112A may include a silicon oxide film, a silicon nitride film, a silicon oxynitride film, or a combination thereof. For example, portions of the device isolation film 112, which have a relatively small width in a lateral direction (e.g., X direction or Y direction), may include only a silicon oxide film, and portions of the device isolation film 112, which have a relatively great width in the lateral direction, and the interface device isolation film 112A may include an outer silicon oxide film, a silicon nitride film surrounded by the outer silicon oxide film, and an inner silicon oxide film surrounded by the silicon nitride film.

As illustrated in FIG. 11, in a plan view (X-Y plane), the interface device isolation film 112A may have a shape surrounding the cell array region CELL. A plurality of dummy active regions DAC, which are defined by the interface device isolation film 112A in the substrate 102, may be arranged in the interface region IF. Each of the plurality of dummy active regions DAC may be surrounded by the interface device isolation film 112A in a plan view (X-Y plane). The plurality of dummy active regions DAC may be located only in two second interface regions IF2, from among two first interface regions IF1 and the two second interface regions IF2, which are included in the interface region IF adjacent to the cell array region CELL. In each of local regions of two second interface regions IF2 that are spaced apart from each other in the second lateral direction (Y direction) with the cell array region CELL therebetween, the plurality of dummy active regions DAC may be spaced apart from each other in the first lateral direction (X direction) and be arranged in a line in the first lateral direction (X direction).

As illustrated in FIGS. 6, 9, and 10, the IC device 100 may include a plurality of word lines WL, which intersect with the plurality of cell active regions A1 and extend lengthwise in the first lateral direction (X direction) at a vertical level lower than a vertical level of an uppermost surface of the substrate 102 in the cell array region CELL. A vertical level may refer to a relative location along a vertical direction (Z direction - otherwise known as a third direction) that is perpendicular to the first lateral direction and the second lateral direction. A vertical level may refer to a distance from an upper surface of the substrate 102 in the vertical direction. The plurality of word lines WL may extend parallel to each other. A lower surface and a sidewall of each of the plurality of word lines WL may be covered by a gate dielectric film 116, and an upper surface of each of the plurality of word lines WL may be covered by a buried insulating film 120. As illustrated in FIG. 6, a plurality of recess spaces 120R may be formed in an upper surface of the buried insulating film 120.

In embodiments, the plurality of word lines WL may include titanium (Ti), titanium nitride (TiN), tantalum (Ta), tantalum nitride (TaN), tungsten (W), tungsten nitride (WN), titanium silicon nitride (TiSiN), tungsten silicon nitride (WSiN), or a combination thereof, without being limited thereto. The gate dielectric film 116 may include a silicon oxide film, a silicon nitride film, a silicon oxynitride film, an oxide/nitride/oxide (ONO) film, or a high-k dielectric film having a higher dielectric constant than a silicon oxide film. For example, the gate dielectric film 116 may include HfO₂, Al₂O₃, HfAlO₃, Ta₂O₃, or TiO₂, without being limited thereto. The buried insulating film 120 may include a silicon oxide film, a silicon nitride film, a silicon oxynitride film, or a combination thereof, without being limited thereto.

A buffer film 122 may be formed on the substrate 102. The buffer film 122 may include a first insulating film 122A and a second insulating film 122B. Each of the first insulating film 122A and the second insulating film 122B may include a silicon oxide film, a silicon nitride film, a silicon oxynitride film, a metal oxide film, or a combination thereof, without being limited thereto.

A plurality of direct contacts DC may be formed on the substrate 102. Each of the plurality of direct contacts DC may be connected to a selected one of the plurality of cell active regions A1. The plurality of direct contacts DC may include silicon (Si), germanium (Ge), tungsten (W), tungsten nitride (WN), cobalt (Co), nickel (Ni), aluminum (Al), molybdenum (Mo), ruthenium (Ru), titanium (Ti), titanium nitride (TiN), tantalum (Ta), tantalum nitride (TaN), copper (Cu), or a combination thereof.

A plurality of bit lines BL may extend lengthwise in the second lateral direction (Y direction) on the substrate 102 and the plurality of direct contacts DC. The plurality of bit lines BL may extend lengthwise in the second lateral direction (Y direction) from the cell array region CELL to the second interface region IF2 of the interface region IF. The plurality of bit lines BL may be located apart from each other in the first lateral direction (X direction) in the cell array region CELL and the second interface region IF2. Each of the plurality of bit lines BL may include a bit line extension BLE arranged in the second interface region IF2. A bit line extension BLE may be a portion of a bit line BLE that extends out of the cell array region CELL and into the second interface region IF2.

As illustrated in FIGS. 4 and 9, the bit line extension BLE of each of the plurality of bit lines BL may extend onto a selected one of the plurality of dummy active regions DAC located in the second interface region IF2. In each of the plurality of bit lines BL, a portion of an end of the bit line extension BLE, which is far (e.g., farthest) from (e.g., away from or outside) the cell array region CELL, may be arranged to overlap a selected one of the plurality of dummy active regions DAC in a vertical direction (Z direction) in the second interface region IF2.

As illustrated in FIG. 4, in the second lateral direction (Y direction), a first shortest distance LY1 from the cell array region CELL to an end of the bit line extension BLE of each of the plurality of bit lines BL may be less than a second shortest distance LY2 from the cell array region CELL to an end of each of the plurality of dummy active regions DAC, which is farthest from the cell array region CELL. In a portion where the plurality of bit lines BL overlap the plurality of dummy active regions DAC in the vertical direction (Z direction), a width of each of the plurality of dummy active regions DAC in the first lateral direction (X direction) may be greater than a width of the bit line extension BLE of each of the plurality of bit lines BL in the first lateral direction (X direction). In a plan view (X-Y plane), in the first lateral direction (X direction), each of the plurality of dummy active regions DAC may extend further toward the outside of the bit line extension BLE of a corresponding one of the plurality of bit lines BL than both sidewalls of the bit line extension BLE of the corresponding bit line BL. For instance, each of the plurality of dummy active regions DAC may extend in the first lateral direction (X direction) beyond both sidewalls of the bit line extension BLE of the corresponding bit line BL.

As illustrated in FIG. 5, in the cell array region CELL, each of the plurality of bit lines BL may be connected to the cell active region A1 through the direct contact DC. As illustrated in FIGS. 9 and 10, in the cell array region CELL and the second interface region IF2, each of the plurality of bit lines BL may include a lower conductive layer 130, a middle conductive layer 132, and an upper conductive layer 134, which are sequentially stacked on the substrate 102. In embodiments, the lower conductive layer 130, the middle conductive layer 132, and the upper conductive layer 134 may include different materials. In embodiments, the lower conductive layer 130 may include doped polysilicon. Each of the middle conductive layer 132 and the upper conductive layer 134 may include TiN, TiSiN, W, tungsten silicide, or a combination thereof. In embodiments, the middle conductive layer 132 may include TiN, TiSiN, or a combination thereof, and the upper conductive layer 134 may include W.

As illustrated in FIG. 9, in the second interface region IF2, an end of the upper conductive layer 134 may be closer to the cell array region CELL than an end of each of the lower conductive layer 130 and the middle conductive layer 132 in the bit line extension BLE of at least one of the plurality of bit lines BL. Herein, in the second interface region IF2, the end of each of the lower conductive layer 130, the middle conductive layer 132, and the upper conductive layer 134 may refer to a portion of each of the lower conductive layer 130, the middle conductive layer 132, and the upper conductive layer 134, which is farthest from the cell array region CELL in the second lateral direction (Y direction).

Each of the plurality of bit lines BL may be covered by an insulating capping structure. The insulating capping structure may include a lower insulating capping layer 142, an insulating thin film 146, and an upper insulating capping layer 148. Each of the lower insulating capping layer 142, the insulating thin film 146, and the upper insulating capping layer 148 may include a silicon nitride film.

Sidewalls of the plurality of bit lines BL and the insulating capping structure may be covered by a plurality of insulating spacers 152. The plurality of insulating spacers 152 may extend lengthwise in the second lateral direction (Y direction) parallel to the plurality of bit lines BL. The plurality of insulating spacers 152 may include an oxide film, a nitride film, air spacers, or a combination thereof. As used herein, the term "air" may refer to space including the atmosphere or other gases that may be present during a manufacturing process.

As illustrated in FIGS. 5 and 6, in the cell array region CELL, a plurality of buried contacts BC and a plurality of insulating fences 154 may be respectively located between the plurality of bit lines BL. The plurality of buried contacts BC and the plurality of insulating fences 154 may be alternately arranged one-by-one in the second lateral direction (Y direction) between two adjacent ones of the plurality of bit lines BL. Each of the plurality of buried contacts BC may be electrically connected to a selected one of the plurality of cell active regions A1. The plurality of insulating fences 154 may fill the plurality of recess spaces 120R formed in an upper surface of the buried insulating film 120 and may be respectively between the plurality of buried contacts BC. In the second lateral direction (Y direction), both sidewalls of each of the plurality of buried contacts BC may be covered by the plurality of insulating fences 154. Each of the plurality of buried contacts BC may be spaced apart from the bit line BL in the first lateral direction (X direction) with the insulating spacer 152 therebetween. In embodiments, the plurality of buried contacts BC may include doped polysilicon, and the plurality of insulating fences 154 may each include a silicon nitride film.

In the cell array region CELL and the second interface region IF2, a width of each of the plurality of bit lines BL in the first lateral direction (X direction) may be generally constant in the second lateral direction (Y direction). For example, of each of the plurality of bit lines BL, a portion located in the cell array region CELL may have a width in the first lateral direction (X direction), which is equal to or similar to a width of a portion located in the second interface region IF2 in the first lateral direction (X direction).

As illustrated in FIGS. 5, 9, and 10, a plurality of conductive landing pads LP may be arranged on the plurality of bit lines BL in the cell array region CELL. From among the plurality of conductive landing pads LP, some conductive landing pads LP adjacent to an edge portion of the cell array region CELL may be dummy structures that do not contribute to operations of a memory cell array MCA. In embodiments, the plurality of conductive landing pads LP may include a metal, a conductive metal nitride, or a combination thereof. For example, the plurality of conductive landing pads LP may include tungsten (W), without being limited thereto. As illustrated in FIG. 5, the buried contact BC may be connected to the conductive landing pad LP through a conductive contact plug 162. The conductive contact plug 162 may include TiN, without being limited thereto.

As illustrated in FIGS. 4, 7, 8, and 9, a plurality of contact plugs BCP may be arranged in the plurality of bit lines BL in the second interface region IF2. In each of two second interface regions IF2 that are spaced apart from each other in the second lateral direction (Y direction) with one cell array region CELL therebetween and are adjacent to the one cell array region CELL, the plurality of contact plugs BCP may be respectively connected to only every other ones selected from the plurality of bit lines BL (e.g., every other bit line BL) in the first lateral direction (X direction). From among the plurality of bit lines BL illustrated in FIGS. 4, 9, and 10, the bit line BL, which is not connected to the contact plug BCP in one second interface region IF2 adjacent to the cell array region CELL, may have a bit line extension BLE, which is connected to another contact plug BCP in another second interface region IF2 that is adjacent to the cell array region CELL in the second lateral direction (Y direction). For instance, even bit lines BL may be connected to contact plugs BCP in one of the second interface regions IF2, and odd bit lines may be connected to contact plugs BCP in another of the second interface regions IF2 (e.g., opposite to the one of the second interface regions IF2). As illustrated in FIG. 10, from among the plurality of bit lines BL, the bit line BL, which is not connected to the contact plug BCP in one second interface region IF2 adjacent to the cell array region CELL, may have an end surface (i.e., a sidewall of the bit line BL farthest from the cell array region CELL), which is covered by the insulating spacer 152.

As illustrated in FIGS. 7 and 9, the contact plug BCP may extend from above a corresponding selected one of the plurality of bit lines BL to the corresponding bit line BL in the vertical direction (Z direction) and be in contact with and connected to the bit line extension BLE of the corresponding bit line BL. Each of the plurality of contact plugs BCP may be in contact with at least four surfaces facing in different directions, from among surfaces included in the bit line extension BLE of a corresponding one of the bit lines BL.

In the second interface region IF2, each of the plurality of contact plugs BCP may be arranged to overlap a selected one of the plurality of dummy active regions DAC in the vertical direction (Z direction). In embodiments, each of the plurality of contact plugs BCP may have portions in contact with at least four surfaces facing in different directions, from among surfaces included in the bit line extension BLE of a corresponding one of the bit lines BL, and a lower surface in contact with a selected one of the plurality of dummy active regions DAC.

As illustrated in FIG. 9, each of the plurality of contact plugs BCP may include a portion in contact with an upper surface of the middle conductive layer 132 included in the bit line BL corresponding thereto, portions in contact with respective sidewalls of the lower conductive layer 130 and the middle conductive layer 132 included in the bit line BL corresponding thereto, and portions in contact with respective end surfaces farthest from the cell array region CELL, of the lower conductive layer 130, the middle conductive layer 132, and the upper conductive layer 134 included in the bit line BL corresponding thereto. Accordingly, the at least four surfaces of the bit line BL in contact with the contact plug BCP may comprise an end surface, two opposing side surfaces and an upper surface.

As illustrated in FIG. 4, in a plan view (X-Y plane), each of the plurality of contact plugs BCP may be arranged within a range of a selected one of the plurality of dummy active regions DAC. In a lateral direction (e.g., X direction and Y direction), a width of each of the plurality of dummy active regions DAC may be greater than a width of each of the plurality of contact plugs BCP.

As illustrated in FIG. 9, a wiring layer 164P may be arranged on each of the plurality of contact plugs BCP in the second interface region IF2. The wiring layer 164P may be integrally connected to a corresponding one of the plurality of contact plugs BCP. The wiring layer 164P may extend lengthwise in a lengthwise direction (i.e., Y direction) of the bit line BL corresponding thereto at substantially the same level as the plurality of conductive landing pads LP arranged in the cell array region CELL. Herein, a vertical level of each a component refers to distance (e.g., a shortest distance) from the uppermost surface of the substrate 102 to the component in the vertical direction (Z direction). Accordingly, a vertical level of each of the wiring layer 164P and the conductive landing pad LP refers to a shortest distance from the uppermost surface of the substrate 102 in the vertical direction (Z direction). In embodiments, the plurality of conductive landing pads LP, the plurality of contact plugs BCP, and the wiring layer 164P may include the same metal. For example, the plurality of conductive landing pads LP, the plurality of contact plugs BCP, and the wiring layer 164P may each include tungsten (W), without being limited thereto.

As illustrated in FIGS. 5 to 10, respective spaces between the plurality of conductive landing pads LP and a plurality of wiring layers 164P may be filled by an insulating film 170. The insulating film 170 may include a silicon nitride film, a silicon oxide film, or a combination thereof.

As illustrated in FIGS. 9 and 10, a plurality of peripheral transistors PTR may be arranged on the substrate 102 in the core region CORE. The plurality of peripheral transistors PTR may each include a gate dielectric film 128 located on the substrate 102 and a peripheral gate PG located on the gate dielectric film 128. The gate dielectric film 128 may include a silicon oxide film, a high-k dielectric film, or a combination thereof. The high-k dielectric film may include HfO₂, Al₂O₃, HfAlO₃, Ta₂O₃, or TiO₂, without being limited thereto. Similarly to the plurality of bit lines BL arranged in the cell array region CELL, the peripheral gate PG may include the lower conductive layer 130, the middle conductive layer 132, and the upper conductive layer 134, which are sequentially stacked on the gate dielectric film 128. Each of the plurality of peripheral transistors PTR may further include a pair of source/drain regions, which are formed on both sides of the peripheral gate PG in the substrate 102. An upper surface of the peripheral gate PG may be covered by an insulating capping layer 142. A sidewall of the peripheral gate PG may be covered by an insulating spacer 144. Each of the insulating capping layer 142 and the insulating spacer 144 may include a silicon nitride film, without being limited thereto.

As illustrated in FIGS. 9 and 10, an insulating thin film 146 and a gap-fill insulating film 145 may be sequentially stacked on the interface device isolation film 112A in the second interface region IF2. The insulating thin film 146 may include a silicon nitride film, and the gap-fill insulating film 145 may include a silicon oxide film. The gap-fill insulating film 145 may be covered by an upper insulating capping layer 148, and the upper insulating capping layer 148 may be covered by an insulating film 170.

In order to prevent short-circuits from occurring between adjacent ones of the plurality of bit lines BL arranged in the cell array region CELL and the second interface region IF2 of the interface region IF adjacent to the cell array region CELL, the IC device 100 described with reference to FIGS. 1 to 11 may include a plurality of dummy active regions DAC, which are defined in the substrate 102 to be spaced apart from each other by the interface device isolation film 112A in the second interface region IF2. In each of the plurality of bit lines BL, the bit line extension BLE located in the second interface region IF2 may extend to a selected one of the plurality of dummy active regions DAC. Because the bit line extension BLE of the plurality of bit lines BL are located on different dummy active regions DAC separated from each other, the likelihood of short-circuits between adjacent ones of the plurality of bit lines BL through the dummy active regions DAC may be eliminated. In addition, the contact plug BCP extending from above each of the plurality of bit lines BL to the bit line extension BLE of the bit line BL corresponding thereto may be arranged on a selected one of the plurality of dummy active regions DAC and may have a structure in contact with at least four surfaces facing in different directions, of the bit line extension BLE of the bit line BL corresponding thereto on the selected dummy active region DAC. Accordingly, a contact area between the contact plug BCP and the bit line BL may increase, and thus, a contact resistance between the contact plug BCP and the bit line BL may be reduced. Furthermore, according to the inventive concept, a length of each of the plurality of bit lines BL may be shortened such that the plurality of bit lines BL do not extend farther from the cell array region CELL than the plurality of dummy active regions DAC. As a result, warpage defects that may occur due to a relatively great length may be suppressed in each of the plurality of bit lines BL, while reducing areas occupied by the cell array region CELL and the interface region IF. Therefore, the number of dies implemented on a single wafer may increase during a process of manufacturing the IC device 100, and the productivity of the IC device 100 may improve.

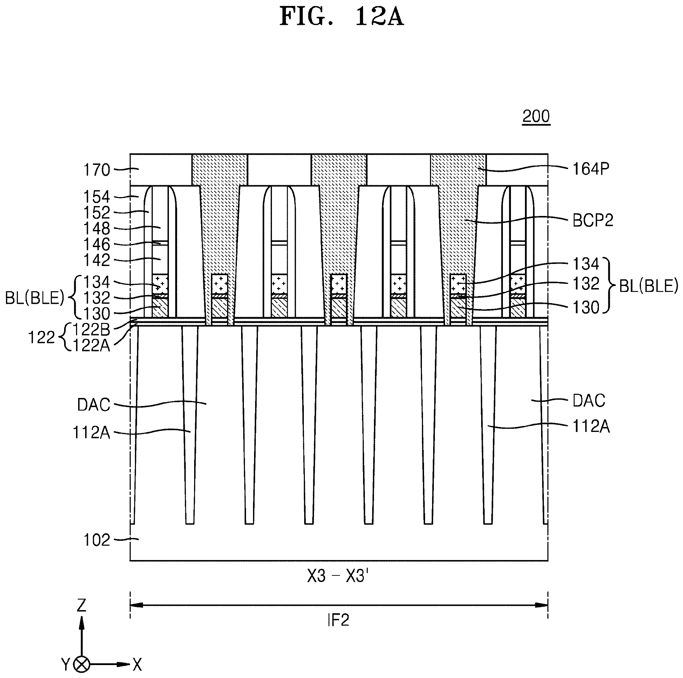

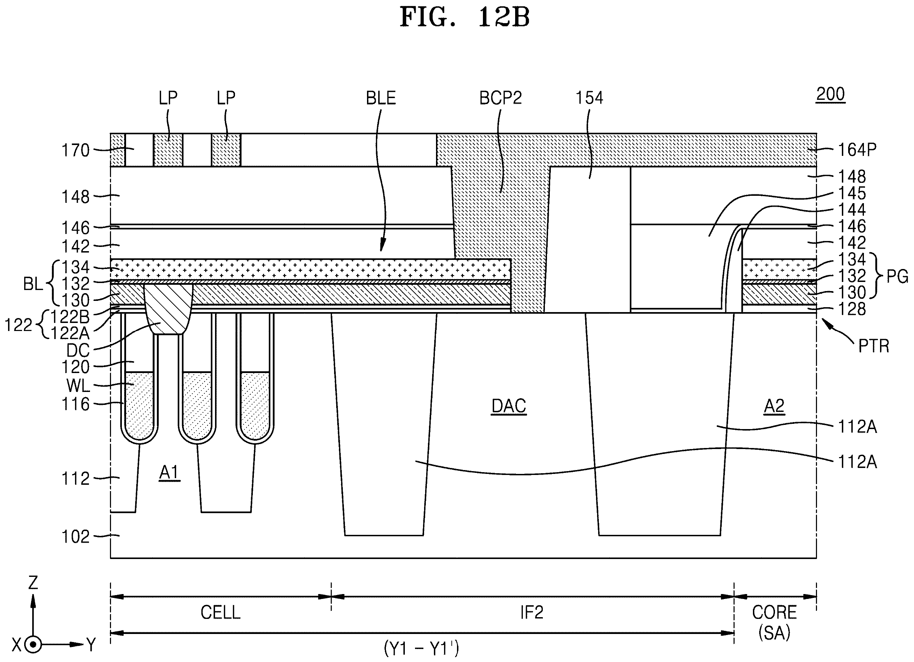

FIGS. 12A and 12B are cross-sectional views of an IC device according to embodiments. More specifically, FIG. 12A illustrates a cross-sectional configuration of a portion corresponding to a cross-section taken along line X3-X3' of FIG. 4 in the IC device 200, and FIG. 12B illustrates a cross-sectional configuration taken along line Y1 - Y1' of FIG. 4 and an extension thereof in the IC device 200. In FIGS. 12A and 12B, the same reference numerals are used to denote the same elements as in FIGS. 1 to 11, and thus, any redundant description thereof is omitted.

Referring to FIGS. 12A and 12B, the IC device 200 may substantially have the same configuration as the IC device 100 described with reference to FIGS. 1 to 11. However, the IC device 200 may include a plurality of contact plugs BCP2 connected to a plurality of bit lines BL in a second interface region IF2. In the second interface region IF2 of the IC device 200, a lower conductive layer 130, a middle conductive layer 132, and an upper conductive layer 134, which are included in a bit line extension BLE of the bit line BL in contact with the contact plug BCP2, may have the same length or similar lengths in a second lateral direction (Y direction).

The plurality of contact plugs BCP2 may substantially have the same configuration as the plurality of contact plugs BCP2 described with reference to FIGS. 4, 7, 8, and 9. Each of the plurality of contact plugs BCP2 may include portions in contact with at least four surfaces facing in different directions, from among surfaces included in the bit line extension BLE of a corresponding one of the bit lines BL, and a lower surface in contact with a selected one of a plurality of dummy active regions DAC. However, each of the plurality of contact plugs BCP2 may include a portion in contact with an upper surface of the upper conductive layer 134 included in the bit line BL corresponding thereto, portions in contact with respective sidewalls of the lower conductive layer 130, the middle conductive layer 132, and the upper conductive layer 134 included in the bit line BL corresponding thereto, and portions in contact with respective end surfaces farthest from a cell array region CELL, of the lower conductive layer 130, the middle conductive layer 132, and the upper conductive layer 134 included in the bit line BL corresponding thereto.

According to the IC device 200 described with reference to FIGS. 12A and 12B, similarly to the IC device 100 described with reference to FIGS. 1 to 11, the likelihood of short-circuits between adjacent ones of the plurality of bit lines BL through the dummy active region DAC may be eliminated, and a contact area between the contact plug BCP2 and the bit line BL may increase, and thus, a contact resistance between the contact plug BCP2 and the bit line BL may be reduced. In addition, a length of each of the plurality of bit lines BL may be shortened such that the plurality of bit lines BL do not extend farther from the cell array region CELL than the plurality of dummy active regions DAC. Thus, warpage defects that may occur due to a relatively great length may be suppressed in each of the plurality of bit lines BL, while reducing areas occupied by the cell array region CELL and an interface region IF including the second interface region IF2. Therefore, the productivity of the IC device 200 may improve.

Next, methods of manufacturing IC devices, according to embodiments, are described in detail.

FIGS. 13A to 23C are diagrams illustrating a process sequence of a method of manufacturing an IC device, according to embodiments. More specifically, FIGS. 13A, 14A, 15A, 16A, 17A, 18A, 19, 20, 22A, and 23A are cross-sectional views of a portion corresponding to a cross-section taken along line X1-X1' of FIG. 3, according to the process sequence, FIGS. 13B, 14B, 15B, 16B, 17B, and 18B are cross-sectional views of a portion corresponding to a cross-section taken along line X2-X2' of FIG. 3, according to the process sequence, FIGS. 17C, 18C, 21A, 22B, and 23B are cross-sectional views of a portion corresponding to a cross-section taken along line X3-X3' of FIG. 4, according to the process sequence, and FIGS. 13C, 15C, 16C, 17D, 18D, 21B, 22C, and 23C are cross-sectional views of a portion corresponding to a cross-section taken along line Y1-Y1' of FIG. 4, according to the process sequence. An example of a method of manufacturing the IC device 100 illustrated in FIGS. 3 to 11 is described with reference to FIGS. 13A to 23C. In FIGS. 13A to 23C, the same reference numerals are used to denote the same elements as in FIGS. 3 to 11, and thus, any redundant description thereof is omitted.

Referring to FIGS. 13A, 13B, and 13C, a plurality of device isolation trenches T1 may be formed in a substrate 102, and a plurality of device isolation films 112 and an interface device isolation film 112A may be formed to fill the plurality of device isolation trenches T1. Thus, a plurality of cell active regions A1 may be defined in a cell array region CELL of the substrate 102, a peripheral active region A2 may be defined in a peripheral circuit region including a core region CORE, and a plurality of dummy active regions DAC may be defined in a second interface region IF2.

A plurality of word line trenches extending parallel to each other may be formed on the substrate 102 in the cell array region CELL. Next, a gate dielectric film 116, a word line WL, and a buried insulating film 120 may be sequentially formed inside each of the plurality of word line trenches. Impurity ions may be implanted into portions of the plurality of cell active regions A1 on both sides of a plurality of word lines WL, and thus, a plurality of source/drain regions may be formed in upper portions of the plurality of cell active regions A1. In embodiments, the plurality of source/drain regions may be formed before the plurality of word lines WL are formed.

Thereafter, a buffer film 122 may be formed by sequentially forming a first insulating film 122A and a second insulating film 122B on a main surface 102M of the substrate 102 in the cell array region CELL and the second interface region IF2, and a gate dielectric film 128 may be formed on the main surface 102M of the substrate 102 in the peripheral circuit region including the core region CORE. The main surface 102M of the substrate 102 may be an upper surface of the substrate 102.

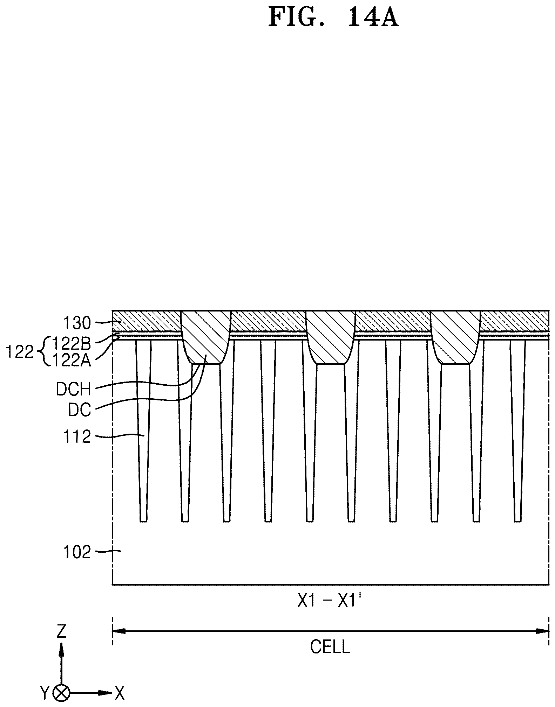

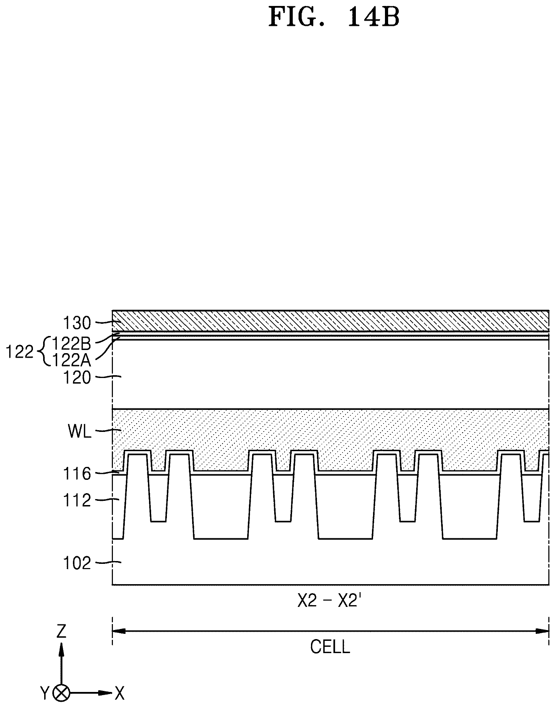

Referring to FIGS. 14A and 14B, in the resultant structure of FIGS. 13A, 13B, and 13C, a lower conductive layer 130 may be formed on the substrate 102 to cover the buffer film 122 and the gate dielectric film 128. Then, partial regions of the lower conductive layer 130 may be etched in the cell array region CELL to expose portions of the substrate 102 and the device isolation films 112. The exposed portions of the substrate 102 and the device isolation films 112 may be etched to form a plurality of direct contact holes DCH exposing the cell active regions A1 of the substrate 102. A plurality of direct contacts DC may be formed to fill the plurality of direct contact holes DCH. During an example of the process of forming the plurality of direct contacts DC, a conductive layer having such a sufficient thickness to fill the direct contact holes DCH may be formed inside the plurality of direct contact holes DCH and on the lower conductive layer 130, and the conductive layer may be etched back such that the conductive layer remains only inside the direct contact holes DCH. The conductive layer may include doped polysilicon, Ge, W, WN, Co, Ni, Al, Mo, Ru, Ti, TiN, Ta, TaN, Cu, or a combination thereof.

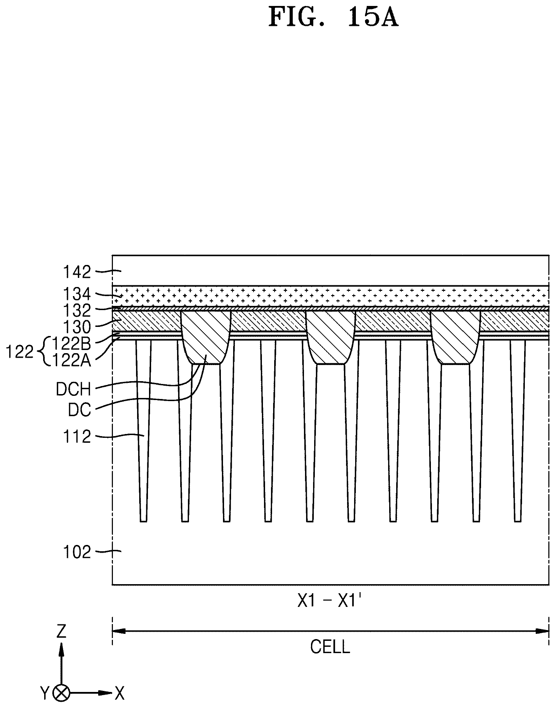

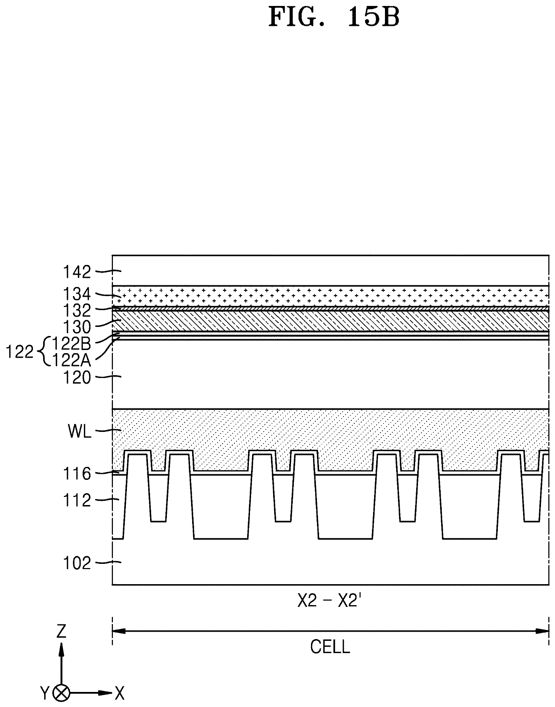

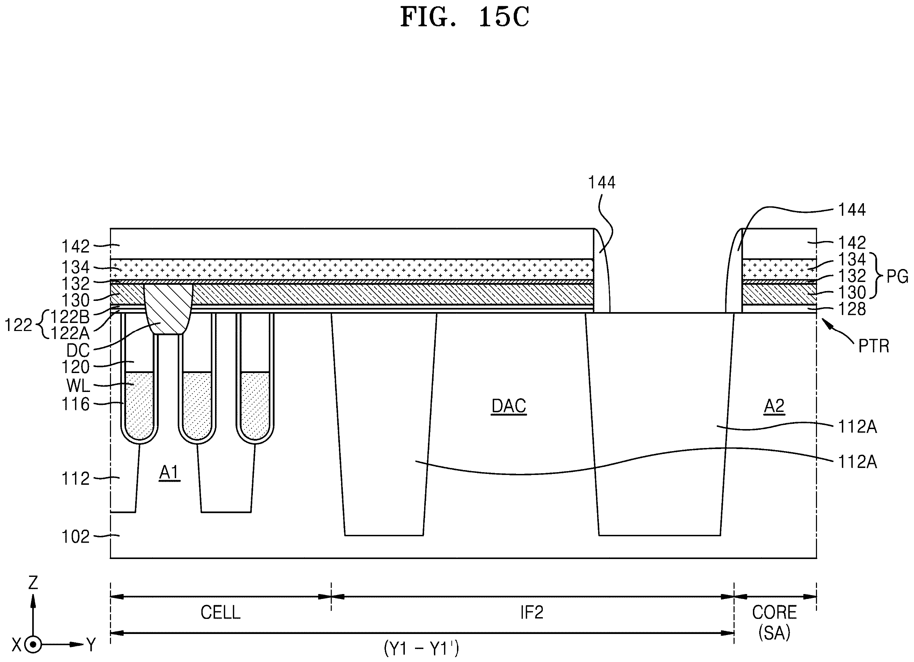

Referring to FIGS. 15A, 15B, and 15C, in each of the cell array region CELL, the second interface region IF2, and the peripheral circuit region including the core region CORE, a middle conductive layer 132, an upper conductive layer 134, and an insulating capping layer 142 may be sequentially formed on the lower conductive layer 130 and the plurality of direct contacts DC. Then, the insulating capping layer 142, the upper conductive layer 134, the middle conductive layer 132, the lower conductive layer 130, the buffer film 122, and the gate dielectric film 128 may be patterned. Thus, a cell stack pattern including the buffer film 122, the lower conductive layer 130, the plurality of direct contacts DC, the middle conductive layer 132, the upper conductive layer 134, and the insulating capping layer 142 may be formed in the cell array region CELL and the second interface region IF2, and a peripheral stack pattern including the gate dielectric film 128, the peripheral gate PG, and the insulating capping layer 142 may be formed in the peripheral circuit region including the core region CORE. Thereafter, an insulating spacer 144 may be formed to cover a sidewall of each of the cell stack pattern and the peripheral stack pattern.

A plurality of peripheral transistors PTR may be formed in the peripheral circuit region including the core region CORE. To form the plurality of peripheral transistors PTR, impurity ions may be implanted into the substrate 102 on both sides of the peripheral gate PG to form a plurality of source/drain regions.

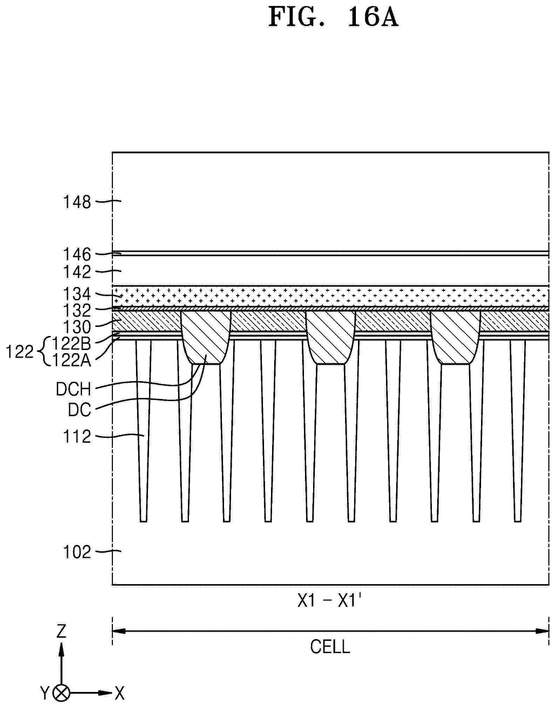

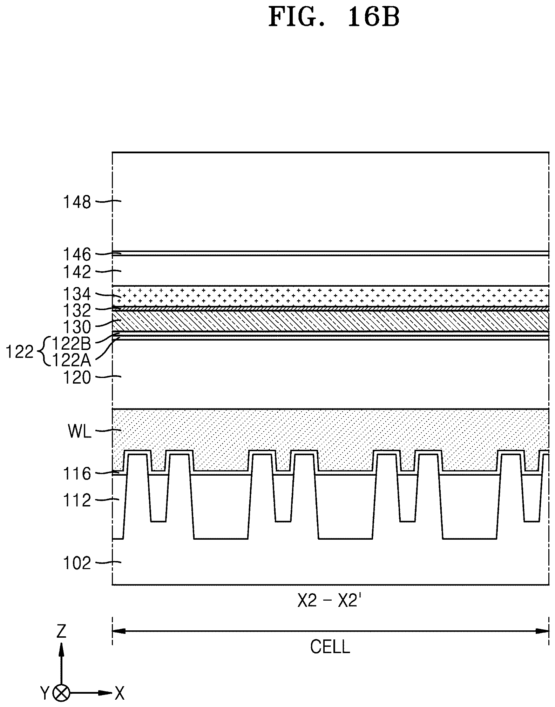

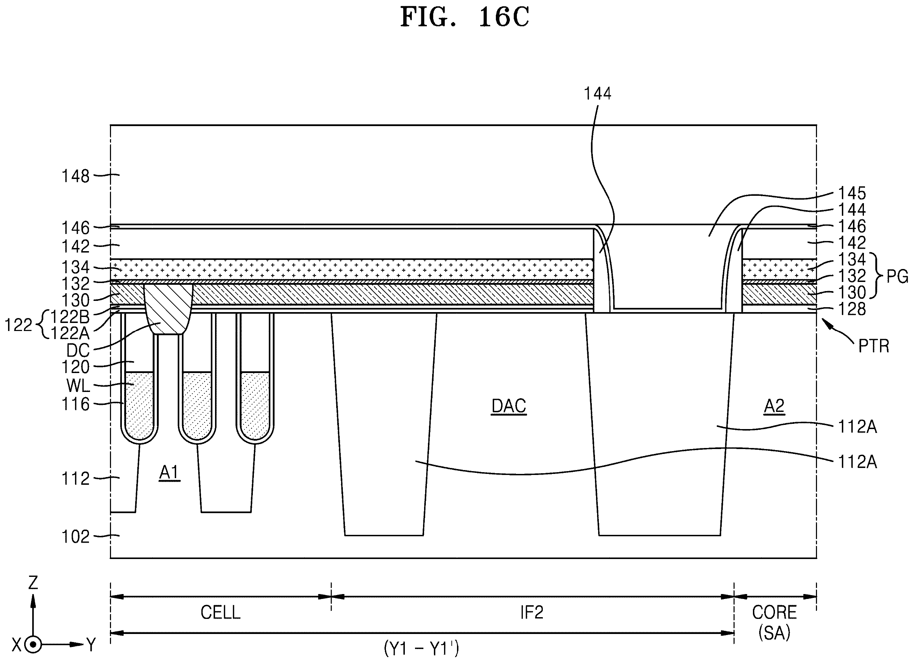

Referring to FIGS. 16A, 16B, and 16C, in the resultant structure on which the processes described with reference to FIGS. 15A, 15B, and 15C have been performed, an insulating thin film 146 may be formed to conformally cover exposed surfaces, and a recess space on the insulating thin film 146 may be filled by a gap-fill insulating film 145. An upper insulating capping layer 148 having a planarized upper surface may be formed on the insulating thin film 146 and the gap-fill insulating film 145.

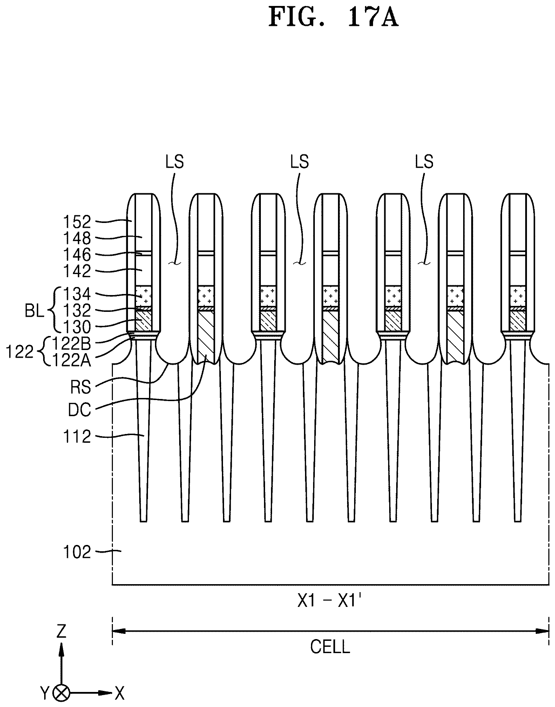

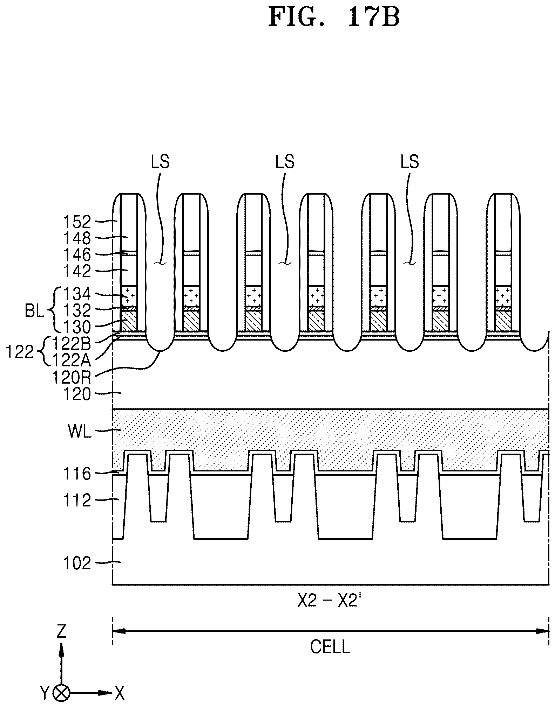

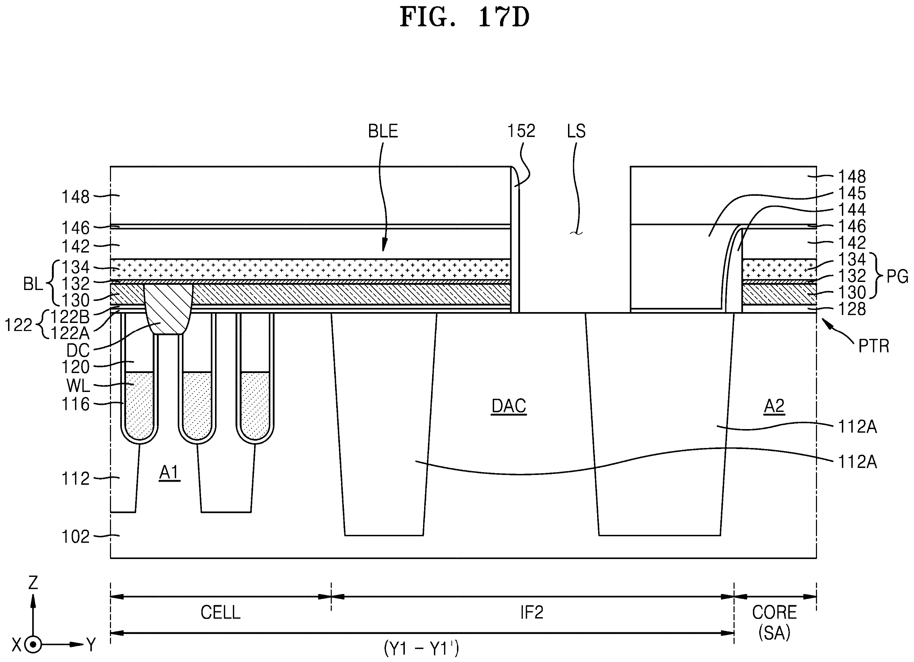

Referring to FIGS. 17A, 17B, 17C, and 17D, in the cell array region CELL of the resultant structure on which the processes described with reference to FIGS. 16A, 16B, and 16C have been performed, the cell stack pattern and the insulating thin film 146 and the upper insulating capping layer 148, which cover the cell stack pattern, may be patterned. Thus, a plurality of bit lines BL may be formed in the cell array region CELL and the second interface region IF2. Also, a plurality of insulating spacers 152 may be formed to cover sidewalls of each of the plurality of bit lines BL and sidewalls of each of the lower insulating capping layer 142 the insulating thin film 146, and the upper insulating capping layer 148, which remain on an upper surface of each of the plurality of bit lines BL. After the plurality of insulating spacers 152 are formed, line spaces LS may respectively remain between the plurality of bit lines BL and adjacent to the plurality of bit lines BL. A height of the upper insulating capping layer 148 may be reduced by etching processes performed during the formation of the plurality of bit lines BL and the plurality of insulating spacers 152.

In the cell array region CELL, the buffer film 122, which is exposed through the line space LS between two adjacent ones of the plurality of bit lines BL, and the substrate 102 located thereunder may be partially etched to form a plurality of recess spaces RS exposing the cell active region A1. During the formation of the plurality of recess spaces RS, partial regions of the buried insulating film 120 may also be etched, and thus, a plurality of recess spaces 120R may be formed in an upper surface of the buried insulating film 120.

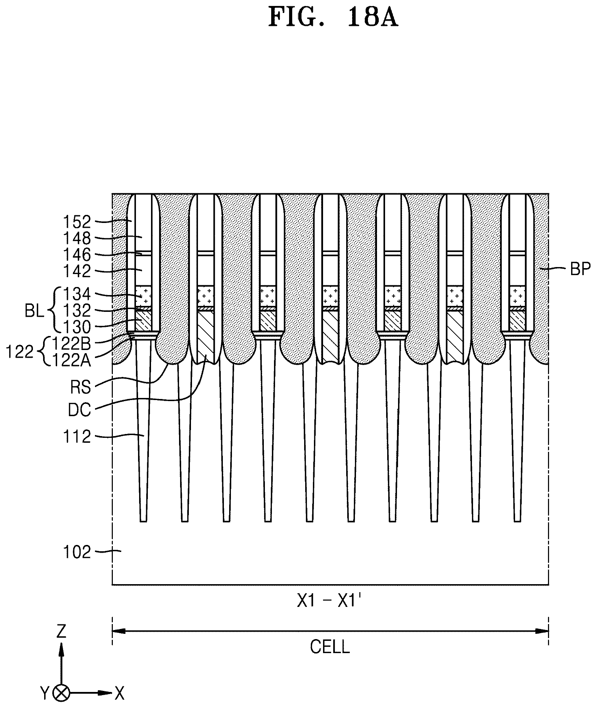

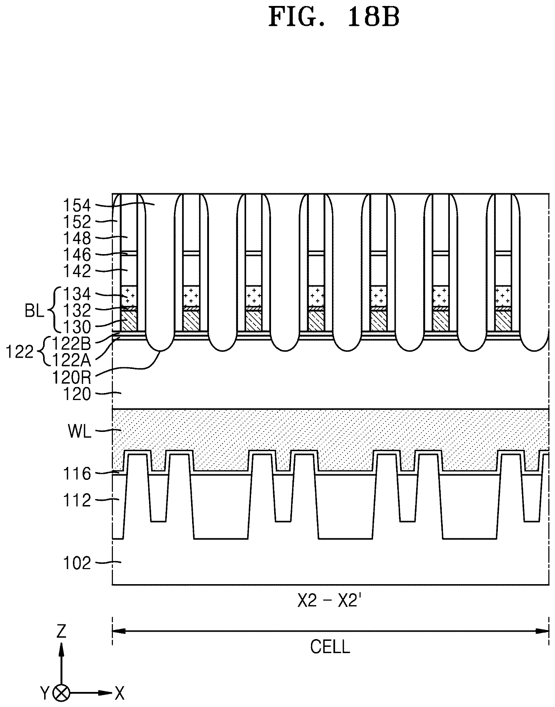

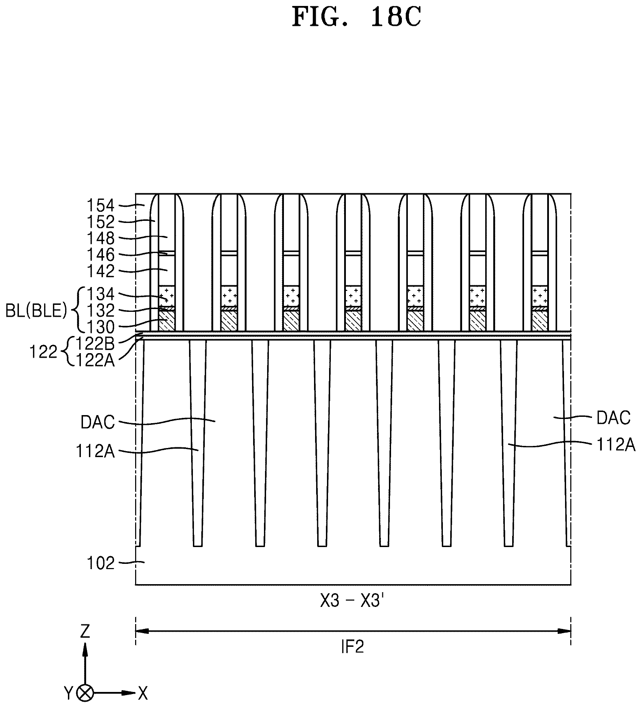

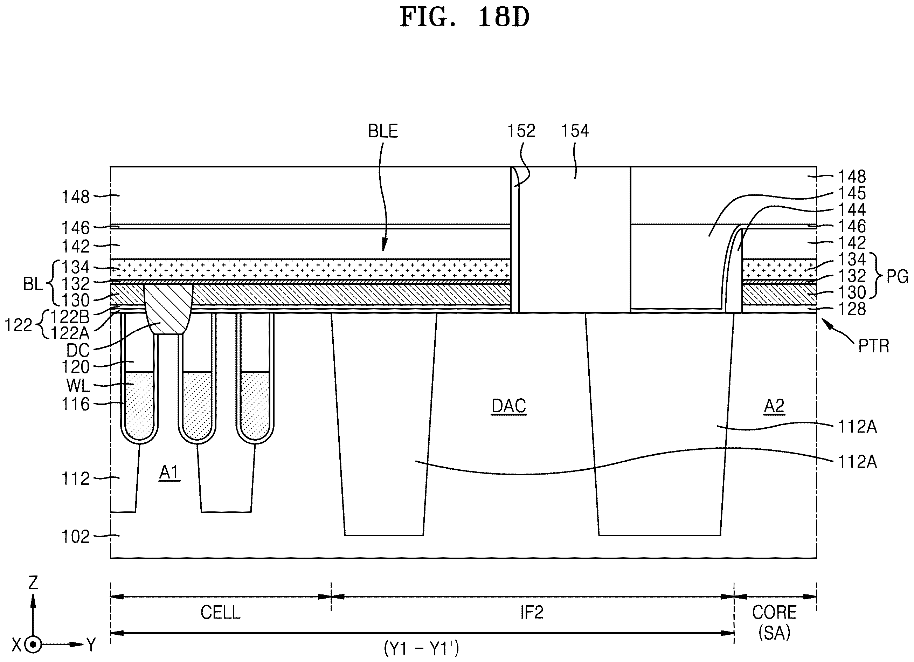

Referring to FIGS. 18A, 18B, 18C, and 18D, a conductive layer may be formed to fill the line space LS between two adjacent ones of the plurality of bit lines BL and the line space LS adjacent to each of the plurality of bit lines BL. The conductive layer may have a linear plane shape extending lengthwise in a second lateral direction (Y direction) in the line space (refer to LS in FIG. 18A) between two adjacent ones of the plurality of bit lines BL. The conductive layer may include doped polysilicon.

Thereafter, in the line space LS, the conductive layer may be patterned and separated into a plurality of conductive patterns BP. An insulating fence 154 may be formed to fill respective spaces between the plurality of conductive patterns BP in the line space LS.

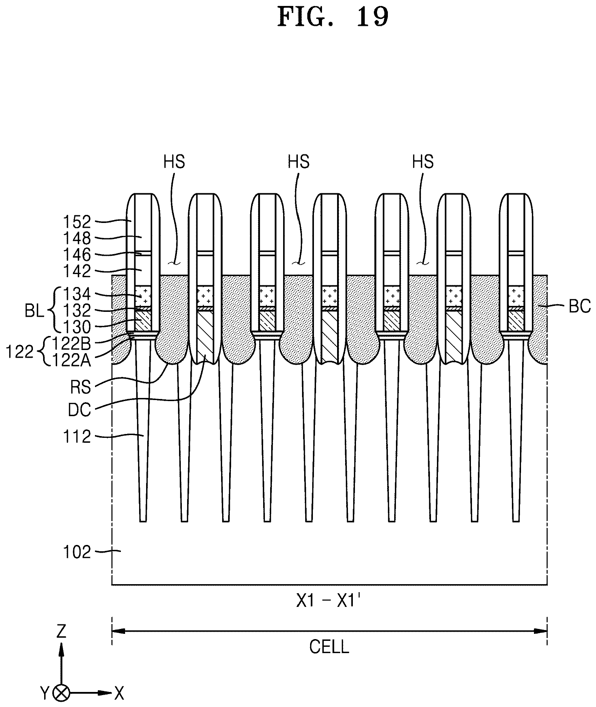

Referring to FIG. 19, in the resultant structure on which the processes of FIGS. 18A, 18B, 18C, and 18D have been performed, a portion may be removed by a partial thickness from an upper surface of each of the plurality of conductive patterns BP to form a plurality of buried contacts BC. After the plurality of buried contacts BC are formed, a space HS may be left on each of the plurality of buried contacts BC.

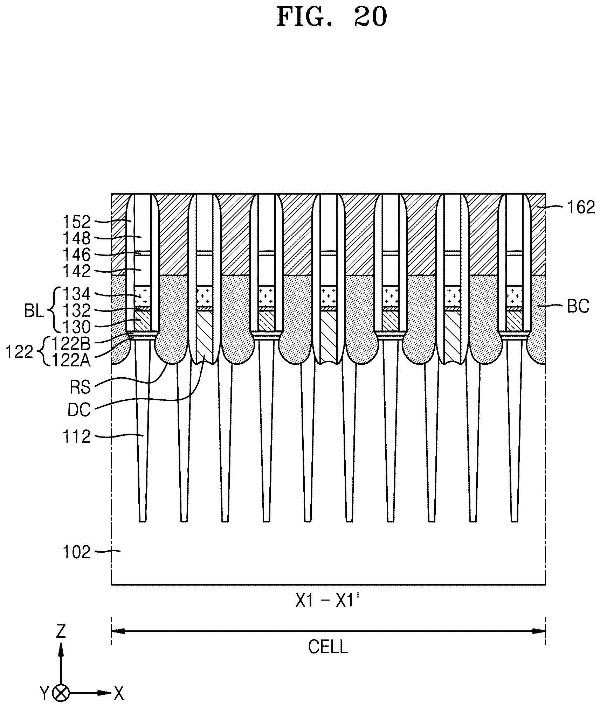

Referring to FIG. 20, in the resultant structure of FIG. 19, a plurality of conductive contact plugs 162 may be formed to cover the plurality of buried contacts BC and fill a plurality of spaces HS, which are respectively left between the plurality of bit lines BL.

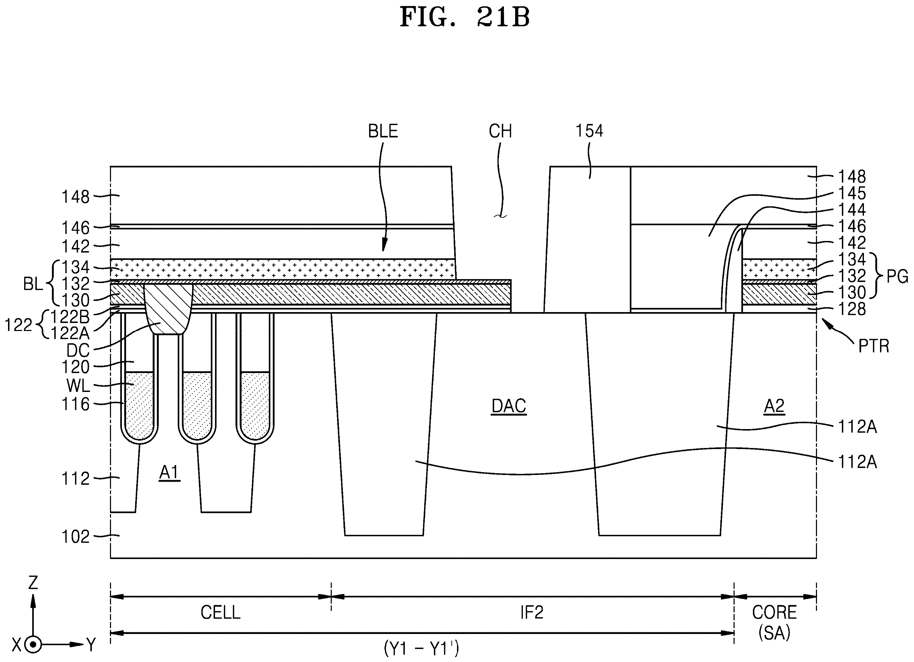

Referring to FIGS. 21A and 21B, in the resultant structure on which the processes described with reference to FIG. 20 have been performed, a plurality of contact holes CH may be formed to expose bit line extensions BLE of the plurality of bit lines BL arranged in two second interface regions IF, which are adjacent to both sides of the cell array region CELL in the second lateral direction (Y direction). The plurality of contact holes CH formed in one of the two second interface regions IF2 are illustrated in FIGS. 21A and 21B. A plurality of contact holes CH exposing bit line extensions BLE of a first group of bit lines BL, which are every other ones selected from the plurality of bit lines BL (e.g., every other bit line BL), may be formed in one of the two second interface regions IF2. A plurality of contact holes CH exposing bit line extensions BLE of another group of bit lines BL, which are every other ones selected from the plurality of bit lines BL and are not included in the first group, may be formed in another one of the two second interface regions IF2.

In the second interface region IF2, the plurality of contact holes CH may be formed at positions overlapping the plurality of dummy active regions DAC in a vertical direction (Z direction). To form the plurality of contact holes CH, a portion of each of the plurality of insulating fences 154, a portion of each of insulating films covering the bit line extensions BLE of every other ones selected from the plurality of bit lines BL, and a portion of the upper conductive layer 134 included in the bit line extension BLE may be etched in the second interface region IF2. Thus, an upper surface of the middle conductive layer 132 included in the bit line extension BLE, a sidewall of each of the lower conductive layer 130 and the middle conductive layer 132, and an end surface of each of the lower conductive layer 130, the middle conductive layer 132, and the upper conductive layer 134, which is farthest from the cell array region CELL, may be exposed through each of the plurality of contact holes CH.

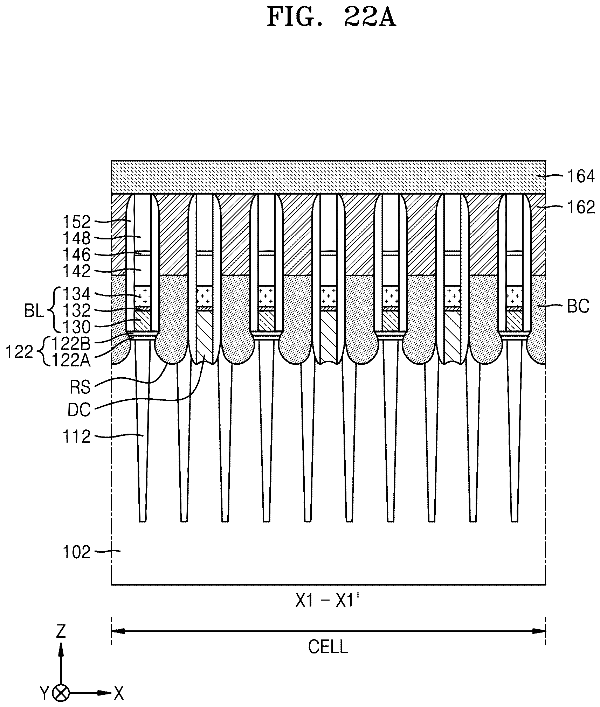

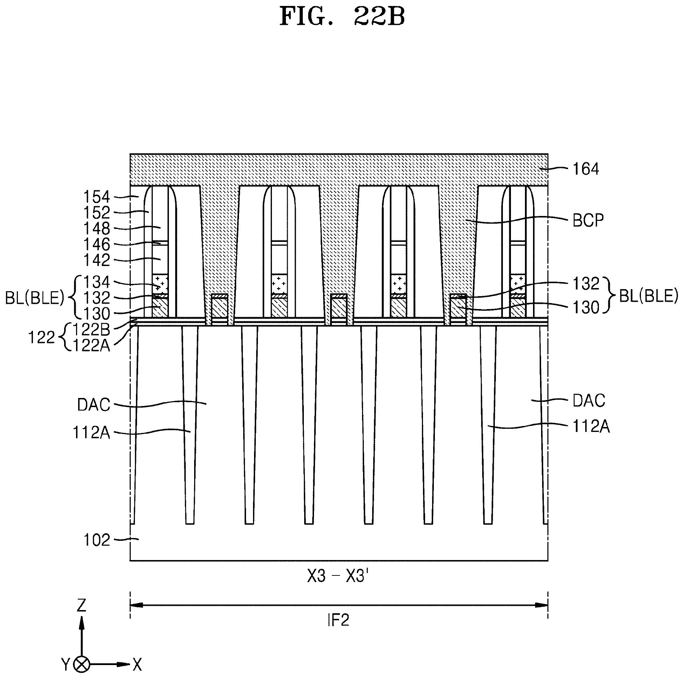

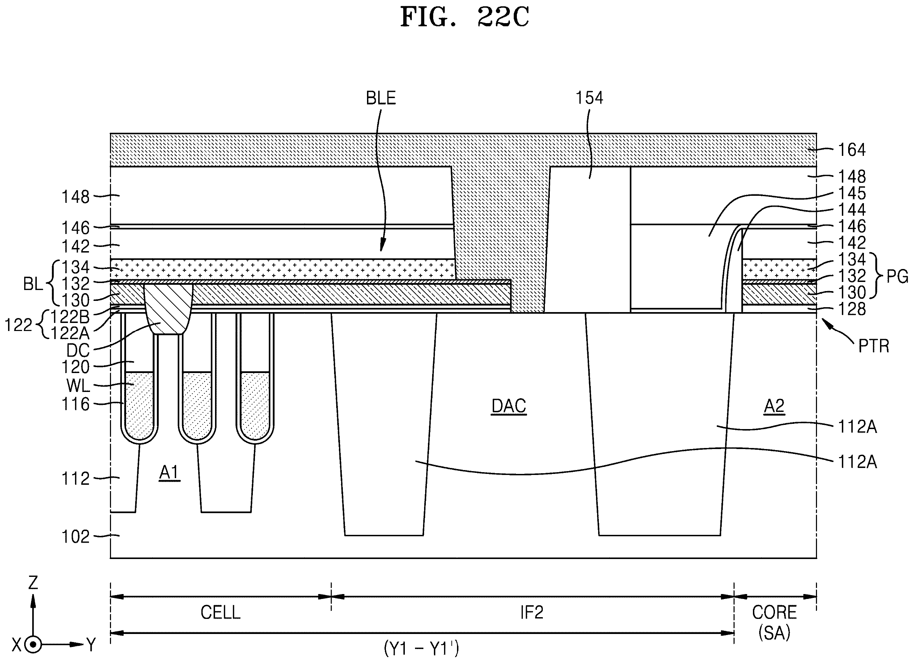

Referring to FIGS. 22A, 22B, and 22C, in the resultant structure on which the processes of FIGS. 21A and 21B have been performed, an upper conductive layer 164 may be formed to fill the plurality of contact holes CH and cover an upper surface of the upper insulating capping layer 148. In embodiments, the upper conductive layer 164 may include tungsten (W).

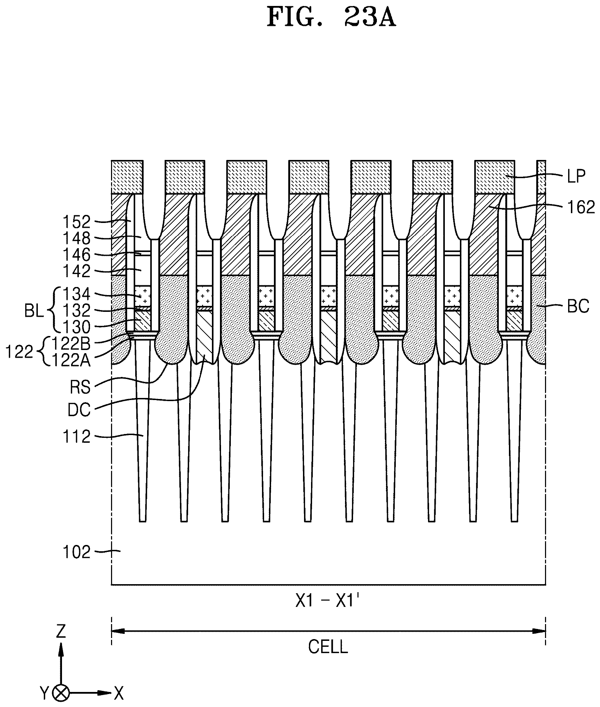

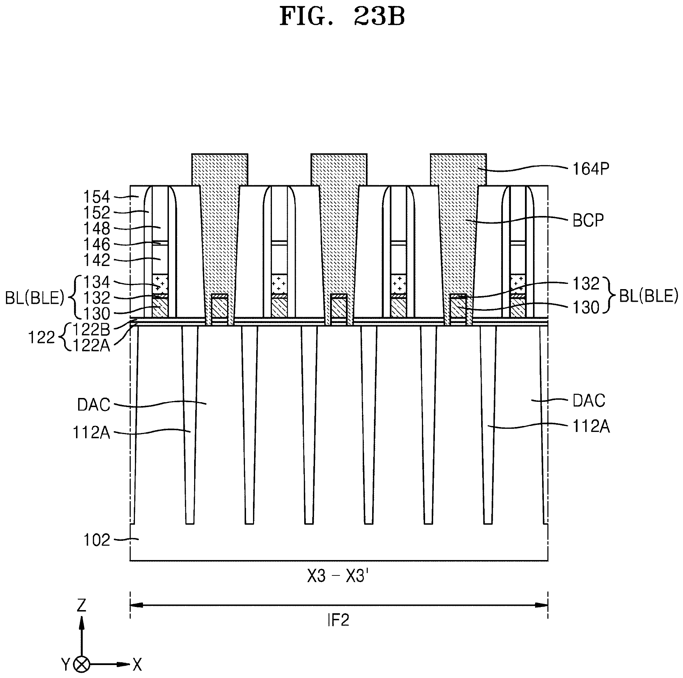

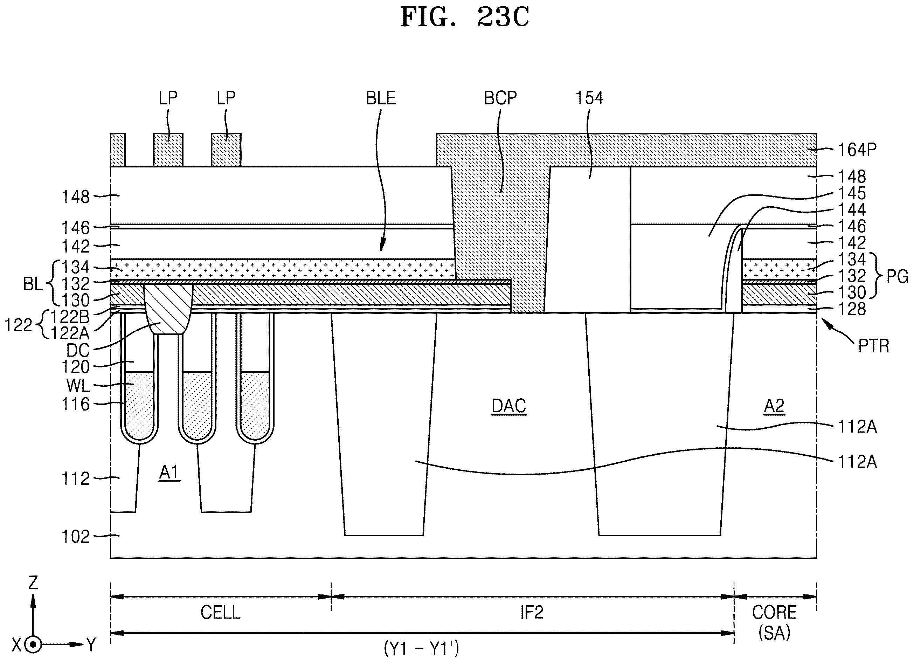

Referring to FIGS. 23A, 23B, and 23C, in the resultant structure on which the processes of FIGS. 22A, 22B, and 22C have been performed, the upper conductive layer 164 may be patterned. Thus, a plurality of conductive landing pads LP may be formed from the upper conductive layer 164 in the cell array region CELL, and a plurality of contact plugs BCP and a plurality of wiring layers 164P may be formed from the upper conductive layer 164 in the second interface region IF2. The plurality of contact plugs BCP may fill the plurality of contact holes CH, respectively, and a plurality of wiring layers 164P may be integrally connected to the plurality of contact plugs BCP, respectively.

Afterwards, in the cell array region CELL, portions of lower structures respectively exposed between the plurality of conductive landing pads LP may be etched. As a result, a portion of each of the plurality of conductive contact plugs 162 and a portion of each of a plurality of upper insulating capping layers 148 and the plurality of insulating spacers 152, which cover the plurality of bit lines BL, may be removed, and thus, a separation space may be provided around each of the plurality of conductive landing pads LP.

Afterwards, as illustrated in FIGS. 5 to 10, an insulating film 170 may be formed to fill respective spaces between the plurality of conductive landing pads LP and the plurality of wiring layers 164P, and thus, the IC device 100 illustrated in FIGS. 3 to 11 may be manufactured.

To manufacture the IC device 200 illustrated in FIGS. 12A and 12B, processes similar to those described with reference to FIGS. 13A to 23C may be performed. However, in the processes described with reference to FIGS. 21A and 21B, instead of the plurality of contact holes CH, a plurality of contact holes may be formed to expose an upper surface of the upper conductive layer 134 included in the bit line extension BLE of each of the plurality of bit lines BL, the sidewall of each of the lower conductive layer 130, the middle conductive layer 132, and the upper conductive layer 134, and respective end surfaces of the lower conductive layer 130, the middle conductive layer 132, and the upper conductive layer 134, which are farthest from the cell array region CELL. Subsequently, the processes described above with reference to FIGS. 22A to 23C may be performed, and thus, the IC device 200 illustrated in FIGS. 12A and 12B may be manufactured.

Although the methods of manufacturing the IC devices 100 and 200 shown in FIGS. 1 to 23C have been described with reference to FIGS. 13A to 23C, it will be understood that IC devices having variously changed structures may be manufactured by applying various modifications and changes to the IC devices 100 and 200, based on the descriptions provided with reference to FIGS. 13A to 23C within the scope of the inventive concept.

It is to be understood that when an element or layer is referred to as being "over", "above", "on", "below", "under", "beneath", "connected to" or "coupled to" another element or layer, it can be directly over, above, on, below, under, beneath, connected or coupled to the other element or layer or intervening elements or layers may be present. In contrast, when an element is referred to as being "directly over", "directly above", "directly on", "directly below", "directly under", "directly beneath", "directly connected to" or "directly coupled to" another element or layer, there are no intervening elements or layers present.

The terms "upper", "middle", "lower" may refer to relative positions along a particular direction (e.g. a vertical direction). Various directions (e.g. vertical direction, lateral direction, etc.) may be defined relative to the structure of the devices described herein. It will be appreciated that these directions do not necessarily imply any particular orientation of the device in use. The terms "upper", "middle", "lower", etc. may be replaced with terms, such as "first", "second", third" to be used to describe relative positions of elements. The terms "first", "second", "third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

As used herein, the singular forms "a", "an", and "the" are intended to include the plural forms as well, unless the context clearly indicates otherwise. Additionally, the description may be specific to a portion of the device and the described structure may be repeated in other portions of the device. For example, the described structure may be an individual element of an array of elements forming the device. Accordingly, where the structure of a single element of a plurality of elements has been described, this structure may equally apply to other elements of the plurality of elements.

Embodiments are set out in the following Clauses:
Clause 1. An integrated circuit device comprising:
   a substrate comprising a cell array region, a core region, and an interface region between the cell array region and the core region;
   an interface device isolation film arranged in the interface region and defining the cell array region;
   a plurality of dummy active regions spaced apart from each other in the interface region, each dummy active region being surrounded by the interface device isolation film; and
   a plurality of bit lines extending from the cell array region to the interface region,
   wherein each of the plurality of bit lines comprises a bit line extension located in the interface region, and the bit line extension extends onto a selected one of the plurality of dummy active regions.
Clause 2. The integrated circuit device of Clause 1, wherein the plurality of dummy active regions are spaced apart from each other in a first lateral direction of the integrated circuit device and arranged in a line in the first lateral direction,
   the plurality of bit lines are spaced apart from each other in the first lateral direction and extend in a second lateral direction of the integrated circuit device, wherein the second lateral direction is perpendicular to the first lateral direction, and,
   in the second lateral direction, a first shortest distance from the cell array region to an end of the bit line extension of each of the plurality of bit lines is less than a second shortest distance from the cell array region to an end of each of the plurality of dummy active regions, which is farthest from the cell array region.
Clause 3. The integrated circuit device of Clause 1 or Clause 2, further comprising a contact plug extending from above a first bit line selected from the plurality of bit lines to the first bit line in a vertical direction of the integrated circuit device, the contact plug being in contact with the bit line extension of the first bit line,
   wherein the contact plug is in contact with at least four surfaces facing in different directions, from among surfaces included in the bit line extension of the first bit line.
Clause 4. The integrated circuit device of any preceding Clause, further comprising a plurality of contact plugs respectively extending from above the plurality of bit lines to the plurality of bit lines in a vertical direction of the integrated circuit device, each of the plurality of contact plugs being connected to a selected one of the plurality of bit lines,
   wherein each of the plurality of contact plugs is arranged to overlap a selected one of the plurality of dummy active regions in the vertical direction.
Clause 5. The integrated circuit device of any preceding Clause, further comprising a contact plug extending from above a first bit line selected from the plurality of bit lines to the first bit line in a vertical direction of the integrated circuit device, the contact plug being in contact with the bit line extension of the first bit line,
   wherein the contact plug has portions in contact with at least four surfaces facing in different directions, from among surfaces included in the bit line extension of the first bit line, and a lower surface in contact with a selected one of the plurality of dummy active regions.
Clause 6. The integrated circuit device of any preceding Clause, wherein the core region comprises a sub-word line driver region and a sense amplifier region,
   the interface region comprises a first interface region between the cell array region and the sub-word line driver region and a second interface region between the cell array region and the sense amplifier region, and
   the plurality of dummy active regions are arranged only in the first interface region, from among the first interface region and the second interface region.
Clause 7. The integrated circuit device of any preceding Clause, wherein each of the plurality of bit lines comprises a lower conductive layer, a middle conductive layer, and an upper conductive layer, which are sequentially stacked on the substrate and comprise different materials from each other, and
   an end of the upper conductive layer is closer to the cell array region than an end of the lower conductive layer in the bit line extension of at least one of the plurality of bit lines.
Clause 8. The integrated circuit device of any preceding Clause, further comprising:
   a plurality of conductive landing pads arranged to overlap the plurality of bit lines in a vertical direction of the integrated circuit device in the cell array region, the plurality of conductive landing pads being configured to be connected to a plurality of cell active regions included in the cell array region of the substrate;
   a contact plug extending from above a first bit line selected from the plurality of bit lines to the first bit line in the vertical direction, the contact plug being in contact with the bit line extension of the first bit line; and
   a wiring layer integrally connected to the contact plug, the wiring layer extending from an upper surface of the contact plug in a lengthwise direction of the first bit line at a same vertical level as the plurality of conductive landing pads,
   wherein the plurality of conductive landing pads, the contact plug, and the wiring layer comprise a same metal.
Clause 9. The integrated circuit device of any preceding Clause, wherein the plurality of dummy active regions are spaced apart from each other in a first lateral direction of the integrated circuit device and arranged in a line in the first lateral direction,
   the plurality of bit lines are spaced apart from each other in the first lateral direction and extend in a second lateral direction of the integrated circuit device, wherein the second lateral direction is perpendicular to the first lateral direction, and
   a width of each of the plurality of dummy active regions is greater than a second width of the bit line extension of each of the plurality of bit lines in the first lateral direction.
Clause 10. The integrated circuit device of any preceding Clause, further comprising a plurality of contact plugs respectively extending from above the plurality of bit lines to the plurality of bit lines in a vertical direction of the integrated circuit device, each of the plurality of contact plugs being connected to the bit line extension of a selected one of the plurality of bit lines,
   wherein, in a plan view, each of the plurality of contact plugs is arranged within a range of a selected one of the plurality of dummy active regions, and
   a first width of each of the plurality of dummy active regions is greater than a third width of each of the plurality of contact plugs in a lateral direction perpendicular to the vertical direction.
Clause 11. An integrated circuit device comprising:
   a substrate comprising a cell array region, a core region surrounding the cell array region, and an interface region between the cell array region and the core region;
   an interface device isolation film arranged in the interface region and defining the cell array region; and
   a plurality of bit lines on the substrate in the cell array region and the interface region, the plurality of bit lines being spaced apart from each other in a first lateral direction of the integrated circuit device and extending in a second lateral direction perpendicular to the first lateral direction, and each bit line comprising a bit line extension located in the interface region; and
   a plurality of dummy active regions in first and second local regions, the plurality of dummy active regions defined by the interface device isolation film in the substrate, wherein the first and second local regions are selected in the interface region and spaced apart from each other in the second lateral direction with the cell array region therebetween,
   wherein the plurality of dummy active regions are spaced apart from each other in the first lateral direction in each of the first and second local regions and are arranged in a line in the first lateral direction, and
   a portion of an end of the bit line extension, which is far from the cell array region, in each of the plurality of bit lines is arranged at a position overlapping a selected one of the plurality of dummy active regions in a vertical direction of the integrated circuit device in the interface region.
Clause 12. The integrated circuit device of Clause 11, wherein, in the second lateral direction, a first shortest distance from the cell array region to the end of the bit line extension of each of the plurality of bit lines is less than a second shortest distance from the cell array region to an end of each of the plurality of dummy active regions, which is farthest from the cell array region.
Clause 13. The integrated circuit device of Clause 11 or Clause 12, further comprising a plurality of contact plugs respectively extending from above the plurality of bit lines to the plurality of bit lines in the vertical direction,
   wherein each of the plurality of contact plugs is in contact with at least four surfaces facing in different directions, from among surfaces included in the bit line extension of a selected one of the plurality of bit lines.
Clause 14. The integrated circuit device of any of Clauses 11-13, further comprising a plurality of contact plugs respectively extending from above the plurality of bit lines to the plurality of bit lines in the vertical direction, each of the plurality of contact plugs being connected to the bit line extension of a selected one of the plurality of bit lines,
   wherein each of the plurality of contact plugs is arranged to overlap a selected one of the plurality of dummy active regions in the vertical direction.
Clause 15. The integrated circuit device of any of Clauses 11-14, further comprising a plurality of contact plugs respectively extending from above the plurality of bit lines to the plurality of bit lines in the vertical direction, each of the plurality of contact plugs being connected to the bit line extension of a selected one of the plurality of bit lines,
   wherein each of the plurality of contact plugs has portions in contact with at least four surfaces facing in different directions, from among surfaces included in the bit line extension, and a lower surface in contact with a selected one of the plurality of dummy active regions.

While the inventive concept has been particularly shown and described with reference to embodiments thereof, it will be understood that various changes in form and details may be made therein without departing from the scope of the following claims.

## Claims

1. An integrated circuit device comprising:
a substrate (102) comprising a cell array region (CELL), a core region (CORE), and an interface region (IF) between the cell array region (CELL) and the core region (CORE);
an interface device isolation film (112A) arranged in the interface region (IF) and defining the cell array region (CELL);
a plurality of dummy active regions (DAC) spaced apart from each other in the interface region (IF), each dummy active region (DAC) being surrounded by the interface device isolation film (112A); and
a plurality of bit lines (BL) extending from the cell array region (CELL) to the interface region (IF),
wherein each of the plurality of bit lines (BL) comprises a bit line extension (BLE) located in the interface region (IF), and the bit line extension (BLE) extends onto a selected one of the plurality of dummy active regions (DAC).

2. The integrated circuit device of claim 1, wherein the plurality of dummy active regions (DAC) are spaced apart from each other in a first lateral direction of the integrated circuit device and arranged in a line in the first lateral direction,
the plurality of bit lines (BL) are spaced apart from each other in the first lateral direction and extend in a second lateral direction of the integrated circuit device, wherein the second lateral direction is perpendicular to the first lateral direction, and,
in the second lateral direction, a first shortest distance from the cell array region (CELL) to an end of the bit line extension (BLE) of each of the plurality of bit lines (BL) is less than a second shortest distance from the cell array region (CELL) to an end of each of the plurality of dummy active regions (DAC), which is farthest from the cell array region (CELL).

3. The integrated circuit device of claim 1 or claim 2, further comprising a contact plug (BCP) extending from above a first bit line selected from the plurality of bit lines (BL) to the first bit line in a vertical direction of the integrated circuit device, the contact plug (BCP) being in contact with the bit line extension (BLE) of the first bit line.

4. The integreated circuit device of claim 3 wherein the contact plug (BCP) is in contact with at least four surfaces facing in different directions, from among surfaces included in the bit line extension (BLE) of the first bit line.

5. The integrated circuit device of claim 3 or claim 4 wherein the contact plug (BCP) has portions in contact with at least four surfaces facing in different directions, from among surfaces included in the bit line extension of the first bit line, and a lower surface in contact with a selected one of the plurality of dummy active regions.

6. The integrated circuit device of any preceding claim, further comprising a plurality of contact plugs (BCP) respectively extending from above the plurality of bit lines (BL) to the plurality of bit lines (BL) in a vertical direction of the integrated circuit device, each of the plurality of contact plugs (BCP) being connected to a selected one of the plurality of bit lines (BL),

7. The integrated circuit device of claim 6, wherein each of the plurality of contact plugs (BCP) is arranged to overlap a selected one of the plurality of dummy active regions (DAC) in the vertical direction.

8. The integrated circuit device of claim 6 or claim 7, wherein each of the plurality of contact plugs (BCP) is in contact with at least four surfaces facing in different directions, from among surfaces included in the bit line extension (BLE) of the selected one of the plurality of bit lines (BL).

9. The integrated circuit device of any of claims 6-8, wherein each of the plurality of contact plugs (BCP) has portions in contact with at least four surfaces facing in different directions, from among surfaces included in the bit line extension (BLE) of the selected one of the plurality of bit lines (BL), and a lower surface in contact with a selected one of the plurality of dummy active regions (DAC).

10. The integrated circuit device of any preceding claim, wherein the core region (CORE) comprises a sub-word line driver region (SWD) and a sense amplifier region (SA),
the interface region (IF) comprises a first interface region (IF1) between the cell array region (CELL) and the sub-word line driver region (SWD) and a second interface region (IF2) between the cell array region (CELL) and the sense amplifier region (SA), and
the plurality of dummy active regions (DAC) are arranged only in the second interface region (IF1), from among the first interface region (IF1) and the second interface region (IF2).

11. The integrated circuit device of any preceding claim, wherein each of the plurality of bit lines (BL) comprises a lower conductive layer (130), a middle conductive layer (132), and an upper conductive layer (134), which are sequentially stacked on the substrate (102) and comprise different materials from each other, and
an end of the upper conductive layer (134) is closer to the cell array region (CELL) than an end of the lower conductive layer (130) in the bit line extension (BLE) of at least one of the plurality of bit lines (BL).

12. The integrated circuit device of any preceding claim, further comprising:
a plurality of conductive landing pads (LP) arranged to overlap the plurality of bit lines (BL) in a vertical direction of the integrated circuit device in the cell array region (CELL), the plurality of conductive landing pads (LP) being connected to a plurality of cell active regions (A1) included in the cell array region (CELL) of the substrate;
a contact plug (BCP) extending from above a first bit line selected from the plurality of bit lines (BL) to the first bit line in the vertical direction, the contact plug (BL) being in contact with the bit line extension (BLE) of the first bit line; and
a wiring layer (164P) integrally connected to the contact plug (BCP), the wiring layer (164P) extending from an upper surface of the contact plug (BCP) in a lengthwise direction of the first bit line at a same vertical level as the plurality of conductive landing pads (LP),
wherein the plurality of conductive landing pads (LP), the contact plug (BCP), and the wiring layer (164P) comprise a same metal.

13. The integrated circuit device of any preceding claim, wherein the plurality of dummy active regions (DAC) are spaced apart from each other in a first lateral direction of the integrated circuit device and arranged in a line in the first lateral direction,
the plurality of bit lines (BL) are spaced apart from each other in the first lateral direction and extend in a second lateral direction of the integrated circuit device, wherein the second lateral direction is perpendicular to the first lateral direction, and
a width of each of the plurality of dummy active regions (DAC) is greater than a second width of the bit line extension (BLE) of each of the plurality of bit lines (BL) in the first lateral direction.

14. The integrated circuit device of any preceding claim, further comprising a plurality of contact plugs (BCP respectively extending from above the plurality of bit lines (BL) to the plurality of bit lines (BL) in a vertical direction of the integrated circuit device, each of the plurality of contact plugs (BCP) being connected to the bit line extension (BLE) of a selected one of the plurality of bit lines (BL),
wherein, in a plan view, each of the plurality of contact plugs (BCP) is arranged within a range of a selected one of the plurality of dummy active regions (DAC), and
a first width of each of the plurality of dummy active regions (DAC) is greater than a third width of each of the plurality of contact plugs (BCP) in a lateral direction perpendicular to the vertical direction.

15. The integrated circuit device of any preceding claim, wherein:
the core region (CORE) surrounds the cell array region (CELL);
the plurality of bit lines (BL) are on the substrate (102) in the cell array region (CELL) and the interface region (IF), the plurality of bit lines (BL) being spaced apart from each other in a first lateral direction of the integrated circuit device and extending in a second lateral direction perpendicular to the first lateral direction;
the plurality of dummy active regions (DAC) are in first and second local regions, and are defined by the interface device isolation film (112A) on the substrate (102), wherein the first and second local regions are in the interface region (IF) and spaced apart from each other in the second lateral direction with the cell array region (CELL) therebetween;
in each of the first and second local regions, the plurality of dummy active regions (DAC) are spaced apart from each other in the first lateral direction and are arranged in a line in the first lateral direction, and
a portion of an end of the bit line extension (BLE), which is furthest from the cell array region (CELL), in each of the plurality of bit lines (BL) is arranged at a position overlapping a selected one of the plurality of dummy active regions (DAC) in a vertical direction of the integrated circuit device in the interface region.
